# EUROPEAN PATENT APPLICATION

(11) **EP 4 770 282 A1**
(43) Date of publication of application: **01.07.2026**
(21) Application number: 24945102.2
(22) Date of filing: 21.06.2024
(51) Int. Cl.: H05K 1/02, H05K 1/18, H05K 3/00

(54) **PRINTED CIRCUIT BOARD ASSEMBLY, PROCESSING METHOD FOR PRINTED CIRCUIT BOARD ASSEMBLY, AND TERMINAL DEVICE**

(71) Applicant: Honor Device Co., Ltd., Shenzhen, Guangdong 518040 (CN)
(72) Inventor: DING, Caihua, Shenzhen, Guangdong 518040 (CN); WANG, Hao, Shenzhen, Guangdong 518040 (CN); QIN, Jun, Shenzhen, Guangdong 518040 (CN); ZONG, Xianbo, Shenzhen, Guangdong 518040 (CN); BAI, Liang, Shenzhen, Guangdong 518040 (CN)
(74) Representative: Henselmann, Alexander Gerhard
(86) International application number: PCT/CN2024/100649
(87) International publication number: WO 2025/260357

(57) **Abstract**

This application discloses a circuit board assembly, a circuit board assembly processing method, and a terminal device, and pertains to the technical field of circuit board processing. The circuit board assembly includes a circuit board, an electronic component, an insulation structure, and a shielding structure. The electronic component is electrically connected to the circuit board. The insulation structure extends from a surface of the electronic component to a bottom surface of a component body of the electronic component, to encapsulate at least the component body. The shielding structure extends from a surface of the insulation structure to the circuit board to cover the electronic component. Space occupied by the circuit board assembly in a thickness direction of the circuit board is smaller, and the insulation structure may be more firmly bonded to the surface of the electronic component and is not prone to peeling and delamination.

## Description

### TECHNICAL FIELD

This application pertains to the technical field of circuit board processing, and in particular, relates to a circuit board assembly, a circuit board assembly processing method, and a terminal device.

### BACKGROUND

To meet convenience and comfort of daily use of the user, terminal devices are currently developing toward thinning and lightening. A circuit board such as a main board of the terminal device is an important carrier for electronic component integration of the terminal device, and occupies relatively large space in the entire device. Therefore, how to implement miniaturization of the circuit board and auxiliary parts of the circuit board plays an important role in thinning and lightening of the entire device.

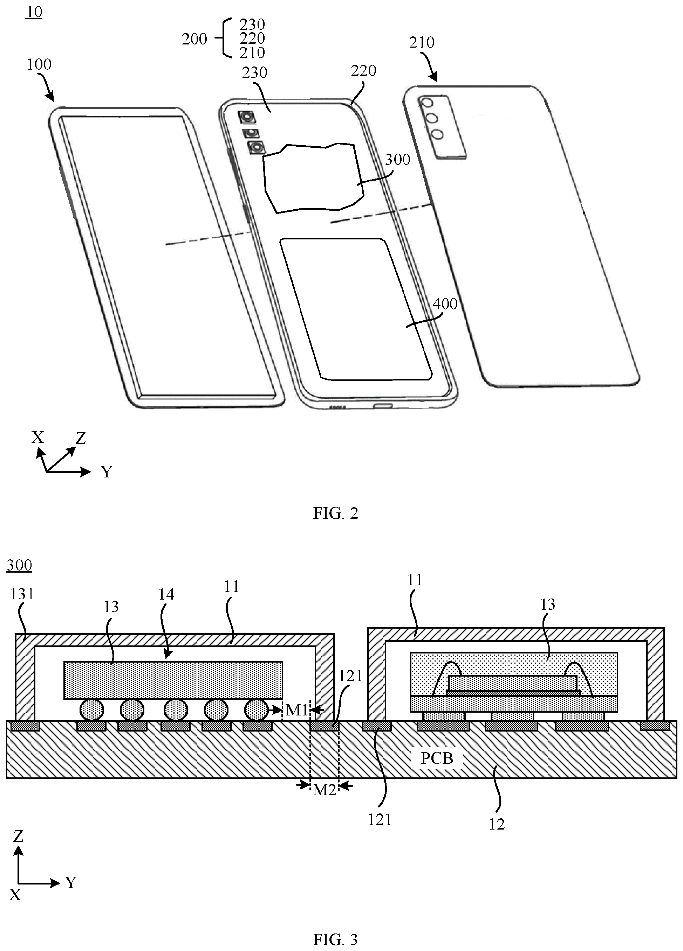

As shown in FIG. 3, in a conventional shielding solution shown in FIG. 3, a shielding cover 11 on a circuit board (Printed Circuit Board, PCB) is welded to a PCB 12, and covers an electronic component 13 on the PCB 12 to shield electromagnetic interference. However, a dimension of the shielding cover 11 in a thickness direction (a Z direction shown in the figure) of the PCB 12 is large, causing a waste of Z-direction space. This is not conducive to further miniaturization, thinning, and lightening of the terminal device.

### SUMMARY

This application provides a circuit board assembly, a terminal device, and a circuit board assembly processing method, to resolve a technical problem of a Z-direction space waste of a current shielding cover.

According to a first aspect, an embodiment of this application provides a circuit board assembly. The circuit board assembly includes a circuit board, an electronic component, an insulation structure, and a shielding structure. The electronic component is electrically connected to the circuit board. The insulation structure extends from a surface of the electronic component to a bottom surface of a component body of the electronic component (that is, a surface that is of the component body and that faces the circuit board), to encapsulate at least the component body, for example, encapsulate the entire electronic component. The shielding structure extends from a surface of the insulation structure to the circuit board to cover the electronic component.

It should be noted that in a conventional shielding solution, a shielding cover is generally an integrated structural component welded to a circuit board, and a size of the shielding cover is on a basis that the electronic component can be covered and there is an insulation gap for insulation between the shielding cover and the electronic component when the electronic component is covered. For a good insulation effect, the electronic component has a safe insulation gap, so that a height of the shielding cover (that is, a size in a Z-direction) is large.

In the circuit board assembly, the insulation structure is disposed on the surface of the electronic component to cover the electronic component, and the shielding structure is disposed on the surface of the insulation structure to cover the electronic component on the circuit board, so that the insulation structure is located between the shielding structure and the electronic component, and plays an insulation function. It can be learned that, different from the shielding cover in the conventional shielding solution, insulation in the circuit board assembly is not dependent on the insulation gap, but on the insulation structure. Because the insulation effect of the insulation structure is higher than that of the insulation gap (essentially air in the insulation gap), the insulation structure can be thinner. When the insulation structure is thinner, because the insulation structure is attached to the surface of the electronic component, and the shielding structure is also attached to the surface of the insulation structure, the shielding structure may be closer to the electronic component and cover the electronic component, so that a height of the shielding structure is shorter than that of the shielding cover, thereby reducing a space waste in a thickness direction of the circuit board, and facilitating further miniaturization and lightening of a terminal device.

In addition, in the circuit board assembly, the insulation structure extends along the surface of the electronic component to the bottom surface of the component body of the electronic component, and is necessarily distributed on the bottom surface of the electronic component. A part attached to the bottom surface of the electronic component may form a stronger pull-off force with the electronic component, and a large attachment area of the entire electronic component is encapsulated with the insulation structure, so that the insulation structure can be more firmly bonded to the surface of the electronic component and is not prone to peeling and delamination, thereby improving reliability in a board-level application environment.

Specifically, the component body is electrically connected to the circuit board through a connection end located at a bottom of the component body. The insulation structure further extends from the bottom surface of the component body to a surface of the connection end, to encapsulate the connection end.

In this embodiment, the insulation structure encapsulates the connection end. The insulation structure can implement a base glue filling function, and disperse a connection end stress, thereby improving electrical connection reliability. In addition, the connection end may be insulated from the outside, to reduce a risk of a short circuit between solder joints.

In some design manners of this application, the insulation structure is an insulation film, and the insulation film is conformally attached to a top surface of the electronic component and extends to a side surface of the electronic component, and is conformally attached to the side surface of the electronic component and extends to at least the bottom surface of the component body. A side that the bottom surface of the component body faces is the bottom surface of the component body.

In this design manner, because the insulation structure is conformally attached by using the insulation film, compared with an embodiment in which a shielding cover and an electronic component are isolated by using an insulation gap in a conventional shielding solution, the electronic component may be conformally isolated, thereby reducing a waste of space of the circuit board assembly in a thickness direction, and facilitating miniaturization and lightening of an entire terminal device. In addition, a thickness of the insulation film is thinner, and space occupied by the insulation film is smaller and there is a weight gain, which is also conducive to lightening and miniaturization of the entire device.

In some embodiments, the electronic component is a chip, and a component body of the chip is electrically connected to the circuit board through a plurality of chip solder ends.

The insulation film extends to at least a bottom surface of the component body of the chip when at least one of the following conditions is met:
a bottom gap H1 of the chip meets 10 µm≤H1≤150 µm;
a recessed dimension of the chip solder end meets W1≥100 µm;
a height D1 of the chip solder end meets 150 µm≤D1≤300 µm; and
a center distance D2 between two adjacent chip solder ends meets 300 µm≤D2≤600 µm.

It should be noted that a chip that has any one of the foregoing four conditions is considered as an electronic component with a small gap at the bottom of the component. In a related technology, an insulation film formed by a hot pressing process has a poor filling capability in a small gap at the bottom of a component of the chip of this type, and even a case in which the insulation film cannot extend to the small gap at the bottom of the component may exist. Consequently, the component body cannot be encapsulated, and the connection end cannot be encapsulated. Therefore, this embodiment provides an insulation film that can be filled at the bottom of such a chip. The insulation film extends to the bottom of the chip body, covers the component body, and even covers the connection end, so that the small gap at the bottom of the component is well filled.

In some embodiments of this application, the electronic component is a passive element, and a component body of the passive element is electrically connected to the circuit board through a plurality of element solder ends. When a bottom gap of the passive element meets H2≤30 µm and/or a recessed dimension of the element solder end meets W2≥30 µm, the insulation film extends to at least a bottom surface of the component body of the passive element. Therefore, this embodiment provides an insulation film that can be filled at the bottom of such passive elements.

It should be noted that a passive element that has any one of the foregoing two conditions is considered as an electronic component with a small gap at the bottom of the component. In a related technology, an insulation film formed by a hot pressing process has a poor filling capability in a small gap at the bottom of a component of the passive element of this type, and even a case in which the insulation film cannot extend to the small gap at the bottom of the component may exist. Consequently, the component body cannot be encapsulated, and the connection end cannot be encapsulated. Therefore, this embodiment provides an insulation film that can be filled at the bottom of such a passive element. The insulation film extends to the bottom of the element body, covers the component body, and even covers the connection end, so that the small gap at the bottom of the component is well filled.

In some embodiments of this application, there are a plurality of electronic components, and there is a gap between the plurality of electronic components. The insulation structure extends into the gap, and extends to the bottom of the component body of the electronic component along a side surface that is of each electronic component and that corresponds to the gap, to encapsulate at least the component body of each electronic component.

It should be noted that in a related technology, a gap between electronic components of an insulation film formed by using a hot pressing process is relatively poor in filling, especially when the gap is relatively small, so that a reliability problem such as peeling and delamination and a film material rupture easily occurs in the insulation film. In this embodiment, the insulation film extends into a gap between the electronic components, and extends along a side surface of each electronic component corresponding to the gap to the bottom surface of the component body of each electronic component, and is necessarily attached to the side surface of the gap corresponding to the electronic component and the bottom surface of the electronic component. Through attachment to a side surface and a bottom surface of a corresponding gap of the electronic component, a stronger pull force may be formed with each electronic component, so that the insulation film may be more firmly attached to the surface of the electronic component without being prone to delamination and film material rupture, thereby improving reliability in a board-level application environment.

Optionally, a width of the gap is 1 µm~50 µm. In this case, it may be considered that there is a small gap between the two electronic components that form the gap, that is, there is a small gap between the components.

It should be noted that in a related technology, a gap between components is filled by using a hot pressing process. This imposes a relatively high requirement on the gap between electronic components, and requires the gap between electronic components to be more than 0.4 mm. It is clear that, this is not conducive to a high-density miniaturization design of the circuit board. Therefore, this embodiment protects an insulation film that can be well filled in a small gap between components with a gap width of 1 µm~50 µm, so that there may be a circuit board layout benefit, which facilitates a high-density miniaturization design of the circuit board.

In some embodiments of this application, there is a groove on a surface of the electronic component. When a groove width H3 of the groove meets 100 µm≤H3≤700 µm and/or a groove depth of the groove meets W3≥20 µm, the insulation film is conformally attached to an inner wall surface of the groove.

It should be noted that an electronic component with a recess on a surface is referred to as a special recess component in this embodiment. When groove filling is performed on the special recess component whose groove meets any one of the foregoing two conditions, in a related technology, due to a factor such as low pressure on an insulation film formed by a hot pressing process (because an inner wall surface of a recessed position of a surface of the special recess component is lower than a surrounding surface), so that the insulation film is not securely attached in a recessed region, and is prone to peeling and delamination due to a factor such as thermal expansion and cold shrinkage. Therefore, this embodiment provides an insulation film that can be conformally attached to the inner wall surface of the groove of the special recess component.

In some embodiments of this application, a thickness difference indicator of the insulation film meets T≤10%, where T=(Ta-Tb)/Ta, and Ta and Tb are thicknesses at any two positions of the insulation film.

It should be noted that the thickness difference indicator T is used to represent thickness consistency of the insulation film. The higher the thickness difference indicator T, the higher the thickness consistency of the insulation film. The lower the thickness difference indicator T, the lower the thickness consistency of the insulation film. It may be understood that a higher thickness consistency of the insulation film represents a more uniform thickness of the insulation film.

Currently, the thickness difference indicator T of the insulation film is not less than 10%. For example, a thickness of the insulation film formed by the hot pressing process is generally 50 µm~150 µm, and a thickness difference between different positions exceeds 30 µm, that is, a lowest thickness difference indicator T of the insulation film formed by the hot pressing process is 20%. Therefore, this embodiment protects an insulation film whose thickness difference indicator T is less than 10%, so that a thickness of the insulation film at each position of the electronic component is more uniform, and a thickness is more uniform, which is conducive to an electrical consistency design.

In some embodiments of this application, a thickness at any position of the insulation film is 0.5 µm~40 µm.

It should be noted that at present, a thickness of an insulation film cannot reach 0.5 µm~40 µm. For example, a thickness of an insulation film formed by a hot pressing process is generally 50 µm~150 µm. Therefore, this embodiment protects an insulation film having a thickness of 0.5 µm~40 µm, so that the thickness of the insulation film is thinner, which is conducive to thinning and lightening of the circuit board assembly.

For example, the insulation film is implemented by using a coating process. The coating process may form the insulation film in the foregoing embodiment.

Compared with the insulation film formed by the hot pressing process, because the coating process converts a thin film material into a gaseous atom, molecule, or ion, and causes the thin film material to be deposited on a surface of an electronic component, a requirement on a gap around the electronic component is low and there is a relatively strong penetration effect. A film material is not compressed and stretched, there is no need to consider a film material stretching property, fluidity, and strength, and the formed insulation film may be formed to extend into a small gap at a bottom of the component and a small gap between the components for conformal encapsulation, thereby reducing a risk of a problem that the insulation film is peeled off or the film is broken.

In addition, compared with an insulation film formed by a hot pressing process, the coating process forms an insulation film in a manner of depositing a thin film material, and a thickness of the film layer does not correlate with a height and a layout density of an electronic component, and does not involve pressing and stretching on the film material by the hot pressing process. Therefore, a thickness difference indicator T of the insulation film may be less than 10%, and a thickness is more uniform.

In addition, compared with an insulation film formed by a hot pressing process, because the coating process does not involve hot pressing on a film material by using pressure, and an insulation film is formed in a deposition manner, it is not easy to peel and delaminate in a case in which the insulation film is not firmly attached to an inner wall surface of a special recess component because of small pressure.

In addition, compared with an insulation film formed by a hot pressing process, a thickness of the insulation film formed by the coating process is more uniform, and does not correlate with a height and a layout density of an electronic component. Therefore, a thickness of the insulation film formed by the coating process may be thinner, and a thickness of a film at a nano-level to a micron-level can be implemented without intentionally thickening the insulation film to prevent a film layer from being broken at a thinnest position. Based on this, the thickness of the insulation film formed by the coating process may be 0.5 µm~40 µm, so that the insulation film is ultra-thin, thereby facilitating overall thinning of the circuit board assembly.

In addition, compared with the insulation film formed by the hot pressing process, the coating process does not involve stretching of the film material by the hot pressing process, and naturally, a case in which the film material is thinned and the film layer is broken due to a large stretching rate is not easy to occur, so that a short circuit between the shielding film and the electronic component is not easy to occur.

In addition, compared with the insulation film formed by the hot pressing process, because the coating process shape does not involve stretching of the film material by the hot pressing process, a case in which the film material is thinned and the film layer is broken due to a large stretching rate is not easy, so that a short circuit is not easy between the shielding film and the electronic component.

In some embodiments of this application, the shielding structure is a shielding film, and the shielding film is conformally attached to a surface of the insulation film and extends to the circuit board. Compared with an integrated structural component shielding cover, in one aspect, an electronic component may be shielded and protected in a random manner, thereby reducing a space waste of a circuit board assembly in a thickness direction, thereby facilitating miniaturization and lightness of an entire terminal device. In addition, the shielding thickness is thinner (because the shielding cover cannot be attached, the shielding cover needs to be thickened to maintain a relatively wide shape). Therefore, a space occupied by the shielding cover is smaller and has a weight gain, which is also conducive to lightening and miniaturization of the whole system.

Optionally, a thickness at any position of the shielding film is 2 µm~40 µm. This embodiment protects a shielding film with a thickness of 2 µm~40 µm, so that the shielding film is thinner, which helps implement lightening and thinning of the circuit board assembly.

In another design manner of this application, the insulation structure is an insulation colloid. The shielding structure includes a conductive frame and a shielding film. The conductive frame encloses a side that a side surface of the electronic component faces. The insulation colloid is filled in the conductive frame, is distributed on a top surface of the electronic component and extends to the side surface of the electronic component, and is distributed on the side surface of the electronic component and extends to the bottom surface of the electronic component. The insulation colloid extends to at least the bottom surface of the component body, and a side that the bottom surface of the component body faces is the bottom surface of the component body. An inner wall surface of the conductive frame fits a side surface of the insulation colloid, and extends to the circuit board along the side surface of the insulation colloid. The shielding film is conformally attached to a top surface of the insulation colloid, extends to a top end that is of the conductive frame and that is away from the circuit board, and is electrically connected to the conductive frame, the side surface of the insulation colloid is a region that is of a surface of the insulation colloid and that corresponds to the side surface of the electronic component, and a top surface of the insulation colloid is a region that is of the surface of the insulation colloid and that corresponds to the top surface of the electronic component.

In this design manner, the insulation colloid is distributed on a top surface, a side surface, and a bottom surface of the electronic component, and the conductive frame and the shielding film are respectively on a side surface and a top surface of the insulation colloid, so that the insulation colloid is insulated between the shielding film and the conductive structure and the electronic component formed by the conductive frame. It can be learned that the circuit board assembly no longer relies on insulation gap insulation, but relies on insulation colloid for insulation. It may be understood that an insulation effect of the insulation colloid is higher than an insulation effect of the insulation gap, so that the insulation colloid can be made thinner (compared with a size of the insulation gap) and attached to a surface of the electronic component. When the insulation colloid may be thinner and the shielding film and the conductive frame are also attached to the surface of the insulation colloid, a shielding structure formed by the shielding film and the conductive frame may be closer to the electronic component and cover the electronic component, so that a height of the shielding structure is shorter than that of the shielding cover, thereby reducing a space waste in a thickness direction, thereby facilitating further miniaturization and thinning of the terminal device.

Optionally, a ratio of a wall height to a wall width of the conductive frame is 2.4~6. A specific value of this proportion is determined according to the height of the electronic component enclosed by the conductive frame and the width of the ground pad on the circuit board connected to the conductive frame. This ratio should not be too large. Otherwise, it is easy to collapse during processing and cannot be shaped.

For example, the insulation colloid is formed by using a spraying process. The material used in the spraying process has a high fluidity (compared with the hot pressing process), so that complete filling around the components can be implemented without holes, and the electronic components can be fully coated. On the one hand, the strength of the circuit board assembly can be increased. In addition, a reliability problem such as peeling and delamination may not easily occur in the insulation colloid, so that reliability of a circuit board assembly in a board-level application environment can be improved.

For example, the shielding film in the foregoing embodiment may be formed by using any one of a spraying process, a printing process, a coating process, or a hot pressing process.

Compared with a shielding film formed by a hot pressing process, a shielding film formed by the coating process extends more easily to a small gap at a bottom of the component and a small gap between the components, and a requirement for a gap at a bottom of the component and a gap between the components is lower, and a film material is thinner and a film layer is not easily broken. For a specific reason, reference may be made to the foregoing related description of forming an insulation film by the coating process.

It may be understood that, when the shielding film extends to a small gap at the bottom of the component, the insulation film may be bound from more regions, thereby reducing a risk of delamination of the inner insulation film from the surface of the electronic component. When the shielding film extends to a small gap between devices, two adjacent electronic components that need to be isolated may be separated, thereby reducing electromagnetic interference between the two electronic components. When the shielding film has a lower requirement for the gap at the bottom of the device, it is also conducive to lightening and miniaturization of the whole device. When the shielding film is required to lower the inter-component gap, it is conducive to the high-density miniaturization design of the circuit board. When the thickness of the shielding film is thinner, a space occupied by the shielding film is smaller and has a weight gain, which is also conducive to lightening and miniaturization of the entire device. When the shielding film is not easy to be thinned and the film is broken, the risk of shielding failure is lower.

Compared with the shielding film formed by the coating process, the shielding film formed by the spraying process or the printing process depends on a material fluidity, and has a weaker penetration to a gap. Therefore, it is not easy to extend to an area between solder joints, and a risk of a short circuit of the shielding film between the two solder joints can be reduced.

Compared with the shielding film formed by the hot pressing process, the shielding film formed by the spraying process or the printing process also has the foregoing advantages of the shielding film formed by the coating process. The following separately describes the foregoing advantages.

Compared with a shielding film formed by a hot-pressing process, a shielding film formed by a spraying process or a printing process is formed in a manner of spraying a thin film material having a relatively high fluidity, and does not involve a hot-pressing process in which a film material is compressed and stretched, and does not need to take account of film stretching, fluidity, and strength. Therefore, a thickness of the film material is more uniform, and does not need to be intentionally thickened in order that a film thickness is not easily broken at a thinnest position, and a thickness of a shielding film formed by a spraying process or a printing process may be more thin, and a thickness of any position of the spraying process or the printing process may be 2 µm~40 µm, and an ultra-thin film is implemented, thereby facilitating overall reduction of a circuit board assembly. Certainly, the hot pressing process may also form a shielding film in this thickness range. However, a requirement for a tool used by the hot pressing process is extremely high, resulting in extremely high costs.

Compared with a shielding film formed by a hot pressing process, because a spraying process and a printing process do not involve compression of a film material and do not need to consider film stretching and strength, fluidity of the film material forms a shielding film that penetrates more easily into a small gap at a bottom of a component and a small gap between components, and naturally, a risk that an inner insulation film is peeled off from a surface of an electronic component and electromagnetic interference between the two electronic components is reduced. In addition, the spraying process and printing process have lower requirements on the gap between the bottom of the device and the gap between the devices, thus facilitating lightweight, miniaturization, and high-density miniaturization design of the whole device.

Compared with the shielding film formed by the hot pressing process, the spraying process and the printing process do not involve stretching the film material by the hot pressing process, and naturally, a case in which the film material is thinned and the film layer is broken due to a large stretching rate is not easy, thereby reducing a risk of shielding failure.

Certainly, when the thickness of the insulation film is reduced (for example, an insulation film is formed by using a coating process), the shielding film may also be formed by using a hot pressing process. Because the insulation thickness is reduced, the whole circuit board assembly is also reduced.

It should be noted that, compared with the foregoing design manner, the insulation colloid formed by using the spraying process is thicker, and a thickness space is occupied relatively much. Therefore, to compensate for occupation of the thickness space by the insulation colloid, this embodiment preferentially forms a shielding film by using a spraying process, a printing process, and a coating process. Compared with a hot pressing process, a shielding thickness formed by a spraying process, a printing process, and a coating process is thinner, so that occupation of a thickness space can be reduced, thereby facilitating further miniaturization and lightness of a terminal device.

In some examples of this application, the circuit board assembly includes a first electronic component and a second electronic component. The first electronic component and the second electronic component are two adjacent electronic components on a circuit board. A row of ground terminals are distributed between the first electronic component and the second electronic component. The shielding structure is electrically connected to a row of ground terminals to form a first shielding cavity covering the first electronic component and a second shielding cavity covering the second electronic component.

In this example, because the shielding structure is attached to molding, it is not necessary to be disposed on the circuit board in a manner fixed to the pad. In this case, a problem of how to isolate the two electronic components needs to be considered. The shielding structure is electrically connected to a row of ground pads between the first electronic component and the second electronic component, so as to be separated into two shielding cavity bodies, and is configured to separately cover the first electronic component and the second electronic component. It can be seen that, compared with a conventional shielding solution, the circuit board assembly is configured with only a row of ground pads between two adjacent electronic components that need to be isolated, thereby having a layout area benefit and facilitating miniaturization of the whole device.

According to a second aspect, an embodiment of this application provides a circuit board assembly processing method. The circuit board assembly processing method includes: electrically connecting an electronic component to a circuit board; forming an insulation structure on a side on which the electronic component is located on the circuit board, so that the insulation structure extends from a surface of the electronic component to a bottom surface of a component body of the electronic component, to encapsulate at least the component body; and forming a shielding structure on the side on which the electronic component is located on the circuit board, so that the shielding structure extends from a surface of the insulation structure to the circuit board to cover the electronic component, to obtain a circuit board assembly.

In some design manners of this application, the forming an insulation structure and a shielding structure on a side on which the electronic component is located on the circuit board includes: forming a conformally attached insulation film on the surface of the electronic component, so that the insulation film is used as the insulation structure to encapsulate at least the component body; and forming a conformally attached shielding film on a surface of the insulation film, so that the shielding film is used as the shielding structure to extend from the surface of the insulation film to the circuit board.

Optionally, the forming a conformally attached insulation film on the surface of the electronic component includes: forming the insulation film on the surface of the electronic component by using a coating process.

In other design manners of this application, the forming an insulation structure and a shielding structure on a side on which the electronic component is located on the circuit board includes: forming a conductive frame on a surface of the circuit board, so that the conductive frame encloses a side that a side surface of the electronic component faces; filling insulation glue in the conductive frame to form an insulation colloid, where the insulation colloid is used as the insulation structure to encapsulate at least the component body; and forming a conformally attached shielding film on a top surface of the insulation colloid, so that the shielding film extends from the top surface of the insulation colloid to a top end that is of the conductive frame and that is away from the circuit board, and is electrically connected to the conductive frame, where the shielding film and the conductive frame form the shielding structure.

Optionally, the filling insulation glue in the conductive frame includes: filling the insulation glue in the conductive frame by using a spraying process.

Optionally, the forming a conformally attached shielding film includes: forming the conformally attached shielding film by using any one of a spraying process, a printing process, a coating process, or a hot pressing process.

According to a third aspect, an embodiment of this application provides a terminal device. The terminal device includes a housing and the circuit board assembly provided in any embodiment according to the first aspect or a circuit board assembly obtained by using the processing method provided in any embodiment according to the second aspect, and the circuit board assembly is located in the housing.

It may be understood that, except for a separate description, for beneficial effects that can be achieved by the circuit board assembly processing method provided in any embodiment according to the second aspect and the terminal device provided in the third aspect, refer to the beneficial effects described in the circuit board assembly provided in the first aspect. Details are not described herein again.

### BRIEF DESCRIPTION OF DRAWINGS

FIG. 1 is a three-dimensional diagram of a terminal device according to an embodiment of this application;
FIG. 2 is a schematic diagram of an exploded structure of the terminal device shown in FIG. 1;
FIG. 3 is a schematic diagram of a structure of a conventional shielding solution for performing electromagnetic shielding by using a shielding cover in the conventional technology;
FIG. 4 is a schematic diagram of a structure of a board-level film shielding solution according to an embodiment of this application;
FIG. 5 is a schematic diagram of a structure of a circuit board assembly according to an embodiment of this application;
FIG. 6 is a schematic diagram of a structure of another circuit board assembly according to an embodiment of this application;
FIG. 7 is a schematic diagram of a positional relationship between an insulation film and a ground pad in FIG. 5;
FIG. 8 is a schematic diagram of a positional relationship between a shielding film, an insulation film, and a ground pad in FIG. 5;
FIG. 9 is a schematic diagram of filling a film material of a circuit board assembly formed by the board-level film shielding solution shown in FIG. 4;
FIG. 10 is a schematic diagram of a structure related to an insulation film in the circuit board assembly shown in FIG. 5;
FIG. 11 is a schematic diagram of a gap required for filling an insulation film in a circuit board assembly formed by the board-level film shielding solution shown in FIG. 4;
FIG. 12 is a schematic diagram of a related structure of an insulation film encapsulating a chip in the circuit board assembly shown in FIG. 5;
FIG. 13 is a schematic diagram of a related structure of an insulation film encapsulating a passive element in the circuit board assembly shown in FIG. 5;
FIG. 14 is a schematic diagram of a concave position of an insulation film on a surface of a component in a circuit board assembly formed by the board-level film shielding solution shown in FIG. 4;
FIG. 15 is a schematic diagram of a related structure of an insulation film encapsulating a special recess component in the circuit board assembly shown in FIG. 5;
FIG. 16 is a schematic diagram of a thickness uniformity problem and a short-circuit risk that exist in a circuit board assembly formed by the board-level film shielding solution shown in FIG. 4;
FIG. 17 is a schematic diagram of a structure related to an insulation thickness in the circuit board assembly shown in FIG. 5;
FIG. 18 is a schematic diagram of a film material rupture problem that exists in a circuit board assembly obtained by using the board-level film shielding solution shown in FIG. 4;
FIG. 19 is a schematic diagram of a structure of another circuit board assembly according to an embodiment of this application;
FIG. 20 is a schematic diagram of a gap required for filling a shielding film in a circuit board assembly formed by the board-level film shielding solution shown in FIG. 4;
FIG. 21 is a schematic diagram of a structure of another circuit board assembly according to an embodiment of this application;
FIG. 22 is a schematic diagram of comparison between a non-closed ring with a notch and a closed ring without a notch according to an embodiment of this application;
FIG. 23 is a top view of the circuit board assembly in the embodiment shown in FIG. 21;
FIG. 24 is a schematic flowchart of a circuit board assembly processing method according to an embodiment of this application;
FIG. 25 is a flowchart of a processing method for the circuit board assembly shown in FIG. 5 according to an embodiment of this application;
FIG. 26 is a structural process flowchart corresponding to the processing method shown in FIG. 25;
FIG. 27 is a structural process diagram of a shielding film of the circuit board assembly shown in FIG. 19 according to an embodiment of this application;
FIG. 28 is a flowchart of a processing method for the circuit board assembly shown in FIG. 21 according to an embodiment of this application; and
FIG. 29 is a structural process flowchart corresponding to the processing method shown in FIG. 28.

### DESCRIPTION OF EMBODIMENTS

To make the objectives, technical solutions, and advantages of embodiments of this application clearer, the following clearly and completely describes the technical solutions in embodiments of this application with reference to the accompanying drawings in embodiments of this application. Clearly, the described embodiments are some rather than all of embodiments of this application. Based on the embodiments of this application, all other embodiments obtained by a person of ordinary skill in the art without creative efforts fall within the protection scope of this application.

The terms "first", "second", and the like in the specification and the claims in this specification are used to distinguish between different objects, and are not used to describe a specific sequence of the objects. In the description of embodiments of this application, unless otherwise stated, "a plurality of" means two or more. For example, "a plurality of processing units" means two or more processing units, and "a plurality of elements" means two or more elements.

The technical term "electrical connection" in embodiments of this application refers to connecting the two electrical components, to implement current transmission and interworking between the electrical components.

In the embodiments of this application, words such as "example" or "for example" are used to represent giving examples, illustrations, or descriptions. Any embodiment or design solution described as "example" or "for example" in the embodiments of this application should not be explained as being more preferred or having more advantages than other embodiments or design solutions. Exactly, use of the words such as "example" or "for example" is intended to present a related concept in a specific manner.

In this embodiment of this application, x~y is used to represent [x, y], and represents that an endpoint number x and an endpoint number y may be taken, or any number between the two endpoint numbers may be taken.

Before the embodiments of this application are described, related nouns related to the embodiments of this application are first described.
1. "Encapsulate" means that an encapsulation piece covers all surfaces of an encapsulated piece exposed to the outside, so that the surface of the encapsulated piece cannot be seen from the outside the encapsulation piece.
   The "encapsulate at least" mentioned in this embodiment of this application means that in addition to encapsulating a structure, more structures may be encapsulated.
2. "Cover" means that a covering piece covers some surfaces of a covered piece exposed to the outside, similar to covering with quilt, so that the surface of the covered piece cannot be seen from a side that a surface of the covering piece faces.
3. "Attach" refers to an attachment state in which a thinner object adheres to a surface of a thicker object, and the thicker object has specific support for the thinner object.
4. "Conformally attach" refers to an attachment piece attached to a surface of an attached piece. A shape of the attachment piece changes according to a surface shape of the attached piece. This does not mean that the shape of the attachment piece is consistent with that of the attached piece in each position, provided that the shapes are approximately consistent.
5. A coating process is a process in which a thin film material (also referred to as a target material or a coating material) is converted into a gaseous atom, a molecule, or an ion by using a physical phenomenon or a chemical reaction in an environment such as a vacuum or a low-pressure gas discharge condition, and is deposited on a surface of a base material, to form a thin film on the surface of the base material.
   For example, the coating process may be various thin film deposition processes, and the thin film deposition process may be chemical vapor deposition (Chemical Vapor Deposition, CVD), physical vapor deposition (Physical Vapor Deposition, PVD), or the like. The PVD may be evaporation, sputtering, ion plating, arc plating, plasma, or the like.
6. A hot pressing process is a method for pressing two or more materials together under heating and pressure, and may be performed under a vacuum condition.
7. A spraying process is a coating method in which a film material with fluidity is dispersed into uniform and fine droplets through pressure or centrifugal force, and is sprayed on a surface of a coating object.
8. A printing process is a printing method in which an ink jet is sprayed on a surface of an object by using a sprayer, and a principle is similar to the spraying process, but the printing process is generally used to print a film layer.

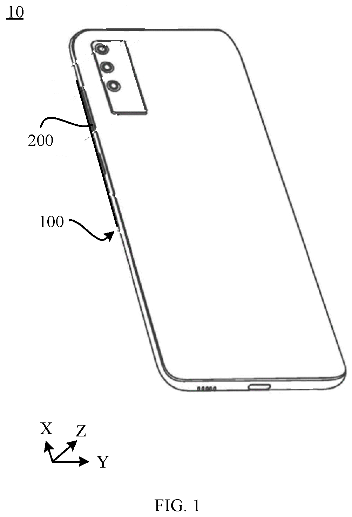

For example, with reference to FIG. 1 and FIG. 2, FIG. 1 is a three-dimensional view of a terminal device 10 according to an embodiment of this application, and FIG. 2 is a schematic diagram of a structure of the terminal device 10 shown in FIG. 1.

The terminal device 10 is a mobile phone, and includes a display 100, a housing 200, and a circuit board assembly 300. The following separately describes each component.

The display 100 is configured to display an image, a video, and other display content.

The housing 200 is configured to carry the display 100. The display 100 and the housing 200 jointly surround accommodating space of the terminal device 10, so that functional components of the terminal device 10 are disposed in the accommodating space, such as the circuit board assembly 300 shown in FIG. 2 and a battery, and the functional component located in the accommodating space is sealed and protected.

As shown in FIG. 2, the housing 200 includes a back cover 210, a side frame 220, and a middle plate 230.

The back cover 210 is also referred to as a battery cover, is located on a backlight side of the display 100, and is stacked with the display 100. It may be understood that a light emitting side of the display 100 is a side facing a screen display area of the display 100, and a side opposite to the light emitting side of the display 100 is the backlight side of the display 100. To facilitate description in the following, an XYZ coordinate system is established. A width direction of the terminal device 10 is defined as a Y-axis direction, a length direction of the terminal device 10 is defined as an X-axis direction, and a thickness direction of the terminal device 10 is defined as a Z-axis direction (Z direction for short). It may be understood that a stacking direction of the display 100 and the back cover 210 in the terminal device 10 is the Z-axis direction. A plane on which the display 100 or the back cover 210 is located is a Z-XY plane. It should be noted that, a coordinate system of the terminal device 10 may be flexibly set according to actual needs.

The side frame 220 is located on a side that is of the back cover 210 and that faces the display 100, and is fastened to the back cover 210. For example, the side frame 220 may be fixedly connected to the back cover 210 by using adhesive. The side frame 220 and the back cover 210 may be of an integrated structure, that is, the side frame 220 and the back cover 210 are of an integral structure.

The middle plate 230 is stacked between the back cover 210 and the display 100, and is fastened to the circumference of an inner surface of the side frame 220. For example, the middle plate 230 may be fastened to the side frame 220 through welding, or the middle plate 230 may be integrally formed with the side frame 220. An integrally formed structure is usually referred to as a middle frame The middle plate 230 serves as a structure "skeleton" of the terminal device 10, and is used to mount functional components such as a circuit board assembly 300 and a battery 400 of the terminal device 10.

As shown in FIG. 2, the circuit board assembly 300 and the battery 400 are installed on a side of the middle plate 230 facing the back cover 210. Certainly, in some other embodiments, the circuit board assembly 300 and the battery 400 may be alternatively installed on a side of the middle plate 230 facing away from the back cover 210. This is not limited in this embodiment of this application.

The circuit board assembly 300 is a structure that includes a circuit board (also referred to as a PCB) and an electronic component integrated on the circuit board. It may be understood that the circuit board may be a main board of the terminal device 10 (this case is shown in FIG. 2), or may be a secondary board of the terminal device 10.

It may be understood that FIG. 1 and FIG. 2 show only an example of some parts included in the terminal device 10. Actual shapes, actual sizes, actual positions, and actual constructions of these parts are not limited by those in FIG. 1 and FIG. 2. In addition, in some other embodiments of this application, the terminal device 10 may include more or fewer parts than those shown in the figure, combine some parts, split some parts, or have different part arrangements.

To shield electromagnetic interference to improve reliability of the circuit board assembly 300, the circuit board assembly 300 generally needs to be provided with some shielding-related structures to perform electromagnetic shielding on the electronic component of the circuit board assembly 300. For example, as shown in FIG. 3, FIG. 3 is a schematic diagram of a structure of a conventional shielding solution for performing electromagnetic shielding by using a shielding cover 11 in the conventional technology. FIG. 3 may be understood as a cross-sectional view of the circuit board assembly 300 shown in FIG. 2 on an X-ZY plane.

In this conventional shielding solution, the shielding cover 11 is usually welded to a PCB 12 of the circuit board assembly 300 by using a solder paste, to cover the electronic component 13 on the PCB 12, to block electromagnetic interference of the electronic component 13 on the PCB 12, and protect the electronic component 13 from mechanical collision. However, in this conventional shielding solution, a dimension (that is, a height) of the shielding cover 11 in a thickness direction (that is, a Z direction shown in the figure) of the PCB 12 is large, which causes a waste of Z-direction space.

To resolve a problem of the height of the shielding cover 11 in the conventional shielding solution, an embodiment of this application provides a board-level shielding integration solution.

Different from the shielding cover 11 in FIG. 3, in the board-level shielding integration solution provided in this embodiment of this application, a structure used to implement electromagnetic shielding is not an integrated structure that is independently formed, but a structure integrated on the PCB 12 and attached to a surface of the electronic component 13. Because attachment is performed on the surface of the electronic component 13, the board-level shielding integration solution has benefits in terms of a height, which facilitates further lightening and miniaturization of the terminal device. The board-level shielding integration solution provided in the embodiments of this application is described below in detail with reference to the accompanying drawings.

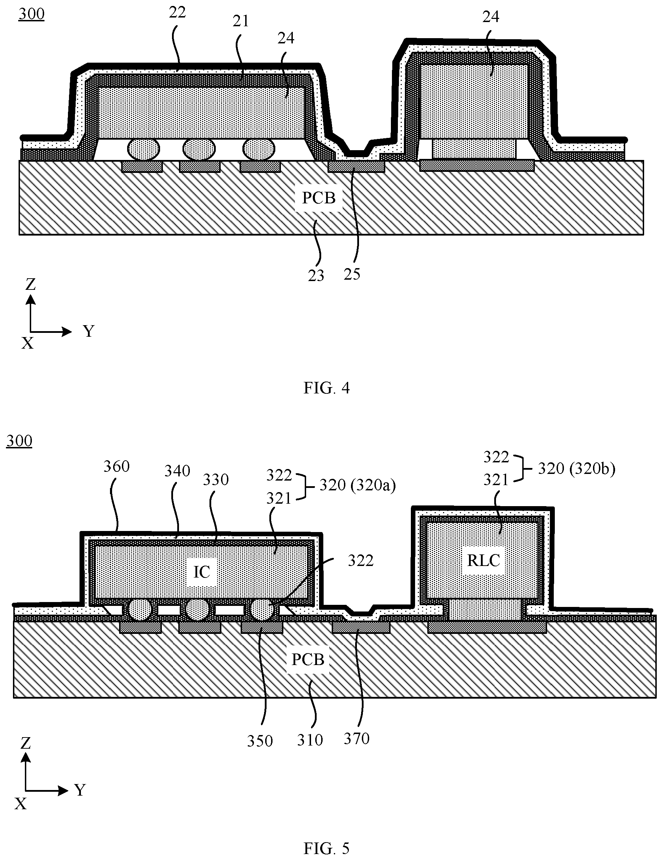

First, an embodiment of this application provides a board-level film shielding solution shown in FIG. 4. The board-level film shielding solution belongs to the board-level shielding integration solution.

FIG. 4 is a schematic diagram of a structure of a board-level film shielding solution according to an embodiment of this application. FIG. 4 may be understood as another cross-sectional view of the circuit board assembly 300 shown in FIG. 2 on an X-ZY plane.

In the board-level film shielding solution shown in FIG. 4, the insulation film 21 and the shielding film 22 cover a PCB 23 of the circuit board assembly 300 by using a hot pressing process, to conformally shield and protect an electronic component 24 on the PCB 23.

The board-level film shielding solution can implement conformal shielding and protection. In addition, the insulation film 21 and the shielding film 22 are thin and successively attached to the electronic component 24. Compared with a case in which an insulation gap 14 needs to be disposed in the conventional shielding solution shown in FIG. 3 to ensure an insulation effect, the board-level film shielding solution can obtain a Z-direction (that is, a thickness direction of the PCB 23) spatial gain, which facilitates thinning of the entire device.

In addition, compared with a case in which the shielding cover 11 in the conventional shielding solution shown in FIG. 3 uses a metal with a high density (such as copper, aluminum alloy, or stainless steel), the insulation film 21 and the shielding film 22 are light thin film layers, and have a weight gain, which facilitates weight reduction of the entire device.

In addition, compared with a PCB 12 layout area occupied by the pad width M1 of the ground pad 121 plus the avoidance width M2 (a width of a gap disposed due to avoidance of the electronic component 13) in the conventional shielding solution shown in FIG. 3, because of a setting of the insulation film 21, the ground pad 25 does not need to avoid the electronic component 24 by using the foregoing relatively wide avoidance width M2, but is isolated by using the thin insulation film 21. Compared with the conventional shielding solution, the board-level shielding solution has a layout area benefit, which facilitates miniaturization of the entire device.

In addition, compared with the conventional shielding solution shown in FIG. 3, two rows of ground pads 121 are required for welding the two shielding covers 11, a shielding film 22 used for isolation between the two electronic components 24 in the board-level shielding solution may be welded to a same row of ground pads 25, so that only one row of ground pads 25 needs to be disposed to form the two shielding cavities for isolation shielding the two adjacent electronic components 24. Therefore, the board-level shielding solution has a layout area gain.

It can be learned that, because shielding integration is implemented in the board-level film shielding solution, a problem of a large layout area, a large weight, and a high height that exist in the conventional shielding solution in FIG. 3 in which the shielding cover 11 is used may be resolved. However, the board-level film shielding solution shown in FIG. 4 introduces a series of new problems, such as a problem that the board-level film shielding solution cannot fill the bottom of the electronic component 24, and a film layer is stripped and delaminated. Subsequently, a problem in the board-level film shielding solution shown in FIG. 4 is described one by one, and no excessive description is provided herein. In view of this, an embodiment of this application further provides another new board-level shielding integration solution. The new board-level shielding integration solution also belongs to the foregoing board-level shielding integration solution, and may be applied to a circuit board assembly of a terminal device.

It should be noted that the terminal device to which the new board-level shielding integration solution provided in this embodiment of this application is applied may be an electronic device that has an electromagnetic interference shielding requirement, such as a mobile phone, a tablet computer, or a notebook computer. A specific form of the terminal device is not specifically limited in this embodiment of this application. In this embodiment of this application, the terminal device 10 shown in FIG. 1 and FIG. 2 is used as an example for description.

The new board-level shielding integration solution may form an insulation structure and a shielding structure on a circuit board of a circuit board assembly, so as to perform electromagnetic interference shielding on an electronic component on the circuit board. Specifically, in the circuit board assembly, the insulation structure extends from the surface of the electronic component to the bottom surface of the component body of the electronic component, so as to at least cover the component body of the electronic component. The shielding structure extends from the surface of the insulation structure to the circuit board to cover the electronic component.

It may be understood that the insulation structure extends along with the surface of the electronic component to the bottom surface of the component body of the electronic component, so as to implement bottom filling of the electronic component. When the insulation structure is filled to the bottom surface of the component body, a part of the insulation structure that extends to the bottom surface of the component body may form a stronger pull-off force with the electronic component, and a larger area of attachment of the insulation structure to the covered component body enables the insulation structure to be more firmly attached to the surface of the electronic component without being prone to delamination, thereby improving reliability in a board-level application environment.

The following describes a new board-level shielding integration solution according to an embodiment of this application with reference to FIG. 5 to FIG. 23.

For example, FIG. 5 is a schematic diagram of a structure of a circuit board assembly 300 according to an embodiment of this application. FIG. 5 may be understood as a cross-sectional view of the circuit board assembly 300 shown in FIG. 2 on an X-ZY plane. The circuit board assembly 300 shown in FIG. 5 uses the foregoing new board-level shielding integration solution.

Specifically, the circuit board assembly 300 includes a circuit board 310 and an electronic component 320.

The circuit board 310 (also referred to as PCB 310) is an important carrier of the electronic component 320, and is generally provided with a metal cable and/or an interface or the like, so as to electrically connect the two electronic components 320 integrated on the PCB 310, and/or electrically connect the electronic component 320 integrated on the PCB 310 to an electronic component that is not integrated on the PCB 310.

The electronic component 320 may be an active component and a passive element. There is at least one electronic component 320. FIG. 5 shows a case of two electronic components 320. For ease of distinction and description, in this embodiment of this application, the two electronic components 320 are respectively referred to as a first electronic component 320a and a second electronic component 320b. The first electronic component 320a is described by using an integrated circuit (integrated circuit, IC) as an example, and the integrated circuit is also referred to as a chip. In the figure, the IC is used to represent the chip. The second electronic component 320b is described by using a passive element as an example. The passive element may be a resistor, an inductor, or a capacitor. As shown in the figure, RLC represents the passive element. It may be understood that a quantity and a type of the electronic component 320 shown in FIG. 5 do not constitute a limitation on the electronic component 320 of the circuit board assembly.

The electronic component 320 is electrically connected to the PCB 310 in a welding manner or the like, and may be electrically connected to another electronic component (for example, an electronic component integrated in the PCB 310 or an electronic component not integrated in the PCB 310) by using a metal cable and/or an interface on the PCB 310.

For example, with reference to FIG. 5, the electronic component 320 includes a component body 321 and a connection end 322 located at a bottom of the component body 321. The bottom of the component body 321 refers to a side that is of the bottom surface of the component body 321 (that is, a surface of the component body 321 toward the PCB 310) and that faces. It may be understood that the bottom of the component body 321 belongs to the bottom of the electronic component 320. In this embodiment of this application, a bottom of the electronic component 320 is sometimes referred to as a bottom of the component.

The component body 321 is a body structure that implements a function of the electronic component 320, and the connection end 322 is a terminal that is of the electronic component 320 and that is configured to be electrically connected to the PCB 310. The component body 321 leads and protrudes from the component body 321 and is electrically connected to the PCB 310, so that the electronic component 320 is electrically connected to the PCB 310, for example, is electrically connected to the component pad 350 on the PCB 310. For example, for the IC shown in FIG. 5, the connection end 322 may be a solder ball, such as a ball grid array (Ball Grid Array, BGA). In the figure, the connection end 322 and the component pad 350 are marked at the IC. It may be understood that the position and the structure of the connection end 322 and the component pad 350 at the RLC may be adaptively understood by reference.

In this example, the connection end 322 is a part of the electronic component 320. Certainly, in some other examples, the connection end 322 may not be considered as a part of the electronic component 320, that is, the electronic component 320 includes the component body 321 but does not include the connection end 322. In this embodiment of this application, the IMSI is used as an example for description.

For ease of understanding and description, in this application, a surface of the component body 321 facing the PCB 310 is referred to as a bottom surface of the component body 321, a surface of the component body 321 facing the PCB 310 is referred to as a top surface of the component body 321 (that is, a surface opposite to a bottom surface of the component body 321), and a surface connected to the top surface and the bottom surface of the component body 321 is referred to as a side surface of the component body 321. It may be understood that, regardless of whether the electronic component 320 includes the connection end 322, a top surface of the electronic component 320 is formed by a top surface of the component body 321, and a side surface of the electronic component 320 is formed by a side surface of the component body 321. When the electronic component 320 includes the connection end 322, a bottom surface of the electronic component 320 includes a non-connection area on a bottom surface of the component body 321 and a non-connection area on a surface of the connection end 322. When the electronic component 320 does not include the connection end 322, a bottom surface of the electronic component 320 includes a non-connection area on a bottom surface of the component body 321. Subsequently, a non-connection area on a bottom surface of the component body 321 and a non-connection area on a surface of the connection end 322 are described.

To implement electromagnetic interference shielding, in the circuit board assembly 300 shown in FIG. 5, an insulation structure in the foregoing new board-level shielding integration solution is implemented by using an insulation film 330 formed by a coating process, and a shielding structure is implemented by using a shielding film 340 formed by a hot pressing process. In the figure, the insulation film 330 and the shielding film 340 are labeled at the IC, and it may be understood that the position and construction of the insulation film 330 and the shielding film 340 at the RLC may be appropriately understood.

First, the insulation film 330 formed by the coating process is described.

The insulation film 330 formed by the coating process is attached to the surface of the electronic component 320, and extends from the surface of the electronic component 320 to the bottom surface of the component body 321 of the electronic component 320 (that is, the surface of the component body 321 toward the PCB 310), so as to cover the component body 321 at least.

The insulation film 330 extends from the surface of the electronic component 320 to the bottom surface of the component body 321, which means that the insulation film 330 extends on the surface of the electronic component 320 and extends to the bottom surface of the component body 321.

For example, FIG. 5 shows a case in which the insulation film 330 covers the entire electronic component 320 (including all the connection terminals 322 and the component body 321). In this case, the insulation film 330 is a coating piece, the electronic component 320 is a coating piece, and an exposed surface of the electronic component 320 includes an exposed surface of the component body 321 and an exposed surface of the connection end 322.

With reference to FIG. 5, it may be learned that a surface of the component body 321 is exposed except an area on which a bottom surface is used for electrical connection (an area on which a bottom surface of the component body 321 is subsequently used for electrical connection becomes a connection area on a bottom surface of the component body 321, and a remaining area is referred to as a non-connection area on a bottom surface of the component body 321). A surface of the connection end 322 is except an area that is used for the electrical connection component body 321 and the PCB 310 (subsequently, the surface of the connection end 322 is used for the electrical connection component body 321 to become a first connection area of the surface of the connection end 322, the surface of the connection end 322 is used for the electrical connection PCB 310 to become a second connection area of the surface of the connection end 322, and a remaining area is referred to as a non-connection area of the surface of the connection end 322).

Therefore, an exposed surface of the electronic component 320 includes a top surface of the component body 321 (that is, a top surface of the electronic component 320), a side surface of the component body 321 (that is, a side surface of the electronic component 320), a non-connection area of a bottom surface of the component body 321, and a non-connection area of a surface of the connection end 322. The non-connection area on the bottom surface of the component body 321 and the non-connection area on the surface of the connection end 322 form an exposed surface on the bottom surface of the electronic component 320.

It may be understood that a bottom surface of the electronic component 320 is formed by a non-connection region on a bottom surface of the component body 321, a non-connection region on a surface of the connection end 322, and a second connection region on a surface of the connection end 322. Because the bottom surface of the electronic component 320 is electrically connected to the PCB 310 by using the second connection region on the surface of the connection end 322, the second connection region on the surface of the connection end 322 included in the bottom surface of the electronic component 320 is not exposed. Therefore, the exposed surface on the bottom surface of the electronic component 320 includes a non-connection area on the bottom surface of the component body 321 and a non-connection area on the surface of the connection end 322.

Based on this, in FIG. 5, the insulation film 330 covers the electronic component 320 by covering the top surface of the electronic component 320, the side surface of the electronic component 320, and the bare surface of the bottom surface of the electronic component 320, so that the surface of the electronic component 320 cannot be seen from outside of the insulation film 330.

Therefore, when the insulation film 330 extends on a surface of the electronic component 320, the insulation film 330 is specifically attached to and bent to a side surface of the electronic component 320 along with a top surface of the electronic component 320, and extends to a non-connection area of the bottom surface of the electronic component 320 along with a side surface of the electronic component 320 and bent to a non-connection area of the connection end 322 of the component body 321, so as to cover the top surface of the electronic component 320, the side surface of the electronic component 320, and the surface bare on the bottom surface of the electronic component 320, thereby implementing coverage of the electronic component 320.

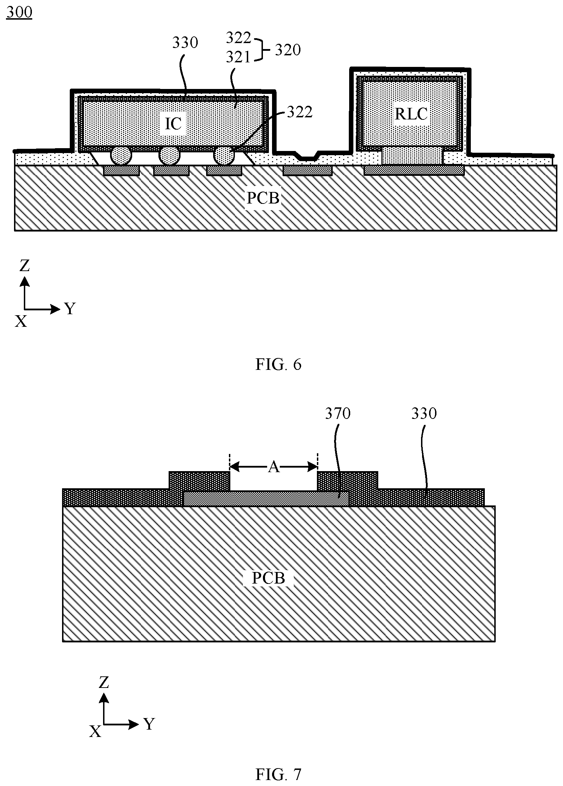

It should be noted that in some other embodiments, the insulation film 330 may further cover only the component body 321 of the electronic component 320 without covering the connection end 322 of the component body 321. This is shown in the circuit board assembly 300 shown in FIG. 6. As shown in FIG. 6, the insulation film 330 is attached to the top surface of the electronic component 320 and bent toward the side surface of the electronic component 320, and is attached to the side surface of the electronic component 320 and bent toward the non-connection region of the bottom surface of the component body 321, so as to cover the top surface of the electronic component 320, the side surface of the electronic component 320, and the non-connection region of the bottom surface of the component body 321, thereby implementing coating of the component body 321.

It may be understood that, compared with the embodiment in which the insulation film 330 is not coated with the connection end 322 in FIG. 6, in FIG. 5, the insulation film 330 is coated with the connection end 322. In one aspect, the insulation film 330 may serve as a base rubber filling function to disperse stress on the connection end 322, thereby improving electrical connection reliability. In addition, the insulation film 330 may further reduce a risk of a short circuit between solder joints. It should be noted that subsequent embodiments are described by using an example in which the insulation film 330 covers the entire electronic component 320.

It may be learned from the foregoing content that the insulation film 330 shown in FIG. 5 is formed by a coating process. In a coating process, a thin film material is converted into a gaseous atom, molecule, or ion, so that the thin film material is deposited on a surface of the electronic component 320. Therefore, the thin film material has a low requirement for a gap around the component and has a relatively strong penetration effect. Therefore, the insulation film 330 formed by the thin film material may be extended to a bottom of the component body of the electronic component 320 to perform type cladding. When the insulation film 330 is formed by using a coating process, the coating material of the insulation film 330 may be an organic material, an inorganic material, or an organic/inorganic composite material that has an insulation characteristic.

For example, an organic material that has an insulation characteristic may be a resin. For example, the resin may be an epoxy resin, a polybenzoxazole (polybenzoxazole, PBO), a Polyimide (Polyimide, PI), a Parylene (polyp-xylene), a PET (polyethylene terephthalate, organic matter), a PTFE (Polytetrafluoroethylene polytetrafluoroethylene, organic matter), a TPU (Thermoplastic Polyurethanes, Thermoplastic Polyurethanes, thermoplastic polyurethane elastomer), a FEP (Fluorinated Ethylene Propylene, Fluorinated Ethylene Propylene, fluorinated ethylene propylene copolymer), a PFA (Perfluoro alkoxy, polytetrafluoroethylene-fluorinated propylene), an HDPE (High-Density Polyethylene high density polyethylene, organic matter). An inorganic material having an insulation characteristic may be boron nitride, silicon nitride, aluminum nitride, alumina, silicon dioxide, or the like.

It should be noted that the insulation film 330 formed by the coating process may extend from a surface of the electronic component 320 to a bottom surface of the component body 321, and the electronic component 320 is coated.

The causes will be analyzed later. Certainly, in some other embodiments, if another process may enable the insulation film 330 to extend from a surface of the electronic component 320 to a bottom surface of the component body 321, the electronic component 320 is coated, which is also within the protection scope of the embodiments of this application.

In some embodiments of this application, referring to FIG. 5, the insulation film 330 extends toward the PCB 310 on the bottom of the component body 321, and is attached to the PCB 310 surface, so as to cover the PCB 310 surface (that is, the upper surface shown in FIG. 5) on the side on which the electronic component 320 is located, thereby improving waterproof performance of the PCB. Certainly, in some other embodiments, the insulation film 330 may not cover the upper surface of the PCB 310, which is not limited in this embodiment of this application. In addition, in FIG. 5, the insulation film 330 is formed integrally. In another embodiment, the insulation film 330 may also be separately coated with each electronic component 320, which is not limited in this embodiment of this application.

Next, a shielding film 340 formed by a hot pressing process is described.

The shielding film 340 is attached to the surface of the insulation film 330, and extends from the surface of the insulation film 330 toward the circuit board 310 to cover the electronic component 320. The shielding film 340 extends from the insulation film 330 surface to the circuit board 310, which means that the shielding film 340 is attached to the insulation film 330 surface to extend to the circuit board 310.

In FIG. 5, the shielding film 340 is a covered part, the electronic component 320 is a covered part, and for a surface exposed to the electronic component 320, refer to the foregoing content. It should be noted that, in this embodiment of this application, the exposed surface of the electronic component 320 is determined when the insulation film 330 is not attached. Based on this, the shielding film 340 may cover all or a part of the top surface of the electronic component 320, the side surface of the electronic component 320, the non-connection region on the bottom surface of the component body 321, and the non-connection region on the surface of the connection end 322, so as to implement coverage of the electronic component 320.

It should be noted that, for this embodiment of this application, the shielding film 340 covers the electronic component 320 on the PCB 310. As a sense of a name, a bottom surface of the electronic component 320 may not be covered, that is, the shielding film 340 covers at least a top surface of the electronic component 320 and a side surface of the electronic component 320, so that the shielding film 340 may be covered on the PCB 310.

In the embodiment shown in FIG. 5, a case in which the shielding film 340 covers the top surface and the side surface of the electronic component 320 without covering the bottom surface of the electronic component 320 is shown. Specifically, the shielding film 340 is attached to and bent to an area of a top surface of the electronic component 320 along with an insulation film 330, and extends to an area of a side surface of the electronic component 320 along with an insulation film 330. The shielding film 340 is attached to and extends to a side surface of the electronic component 320 along with an insulation film 330, and extends to a side surface of the electronic component 320 back to a side surface of the electronic component 320, so as to cover the top surface of the electronic component 320 and the side surface of the electronic component 320, so that the electronic component 320 is covered on the PCB 310. Certainly, in some other embodiments, when the shielding film 340 covers the top surface of the electronic component 320 and the side surface of the electronic component 320, the shielding film 340 may further cover at least a part of the bottom surface of the electronic component 320, so as to cover the electronic component 320 on the PCB 310.

It may be learned from the foregoing content that the shielding film 340 shown in FIG. 5 is formed by a hot pressing process. The hot pressing process may cause the shielding film 340 to extend along the insulation film 330 toward the PCB 310. It should be noted that a thickness of the shielding film 340 formed by the hot pressing process at any position may be 15 µm~100 µm, and a thinner the shielding film 340, a higher requirement for a tool used by the hot pressing process, and a higher cost.

When the shielding film 340 is formed by using a hot pressing process, the hot pressing material of the shielding film 340 may be a material having a conductive characteristic. For example, a material having a conductive characteristic may be a mixture of resin and metal particles (or another conductive material). The resin may be an epoxy resin, PBO, PI, Parylene, PET, PTFE, TPU, FEP, PFA, HDPE, or the like. The metal particles may be any one of copper, nickel, chromium, aluminum, silver, gold, or a metal alloy. The other conductive materials may be graphene or another two-dimensional sheet conductive material.

It should be noted that the shielding film 340 formed by the hot pressing process may be attached to the surface of the electronic component 320 according to a tensile action on a material during compression, and extends toward the PCB 310 on the surface of the insulation film 330, so as to cover the electronic component 320 on the PCB 310. Certainly, in some other embodiments, if another process may cause the shielding film 340 to extend toward the PCB 310 on the surface of the insulation film 330, so as to cover the electronic component 320 on the PCB 310, the shielding film 340 also falls within the protection scope of the embodiments of this application.

Optionally, to improve reliability of the shielding film 340, the circuit board assembly 300 shown in FIG. 5 may further include a protective film 360. The protective film 360 is attached to a surface of the shielding film 340 to protect the shielding film 340. A function of the protective film 360 on the shielding film 340 may be but is not limited to: Anti-wear, anti-metal oxidation, waterproof, electrical isolation, and the like. Certainly, in some other embodiments, the protective film 360 may not be disposed.

In a specific implementation process, the protective film 360 may be implemented by using a hot pressing process, a spraying process, a printing process, and a coating process. A coating process may depend on deposition growth of an atomic coating material, and a spraying process or a printing process depends on material fluidity. Compared with the coating process, the coating process has a weaker penetration to a gap, and a thickness and thickness uniformity of a film are formed.

The material of the protective film 360 may be a material having an insulation characteristic, and may be disposed with reference to the material of the foregoing insulation film 330. A thickness of the protective film 360 formed by a coating process may be 5 µm~15 µm. For example, the thickness of the protective film 360 is 5 µm, 6 µm, 8um, 13 µm, 15 µm.

In the circuit board assembly shown in FIG. 5, an insulation film 330 is disposed on a surface of the electronic component 320 to cover the electronic component 320, and a shielding film 340 is disposed on a surface of the insulation film 330 to cover the electronic component 320 on the PCB 310, so that the insulation film 330 is located between the shielding film 340 and the electronic component 320, and the shielding film 340 and the electronic component 320 are separated, so as to perform an insulation function. It can be learned that, different from the shielding cover 11 shown in FIG. 3, the circuit board assembly is not insulated by the insulation gap 14 shown in FIG. 3, but is insulated by the insulation film 330. The insulation effect of the insulation film 330 is higher than the insulation effect of the insulation gap 14 in FIG. 3 (substantially air in the insulation gap 14), so that the insulation film 330 can be made thinner (compared with a gap size in FIG. 3). When the insulation film 330 is made thinner, because the insulation film 330 is attached to the surface of the electronic component 320 and the shielding film 340 is also attached to the surface of the insulation film 330, a shielding structure formed by the shielding film 340 may be closer to the electronic component 320 and cover the electronic component 320, which makes a height of the shielding structure formed by the shielding film 340 shorter than a shielding cover, thereby reducing space waste in the Z-direction, and further contributing to further miniaturization and lightening of the terminal device.

In addition, the insulation structure is attached with the insulation film 330, and the shielding structure is attached with the shielding film 340. In comparison with the integrated structural component shielding cover 11 shown in FIG. 3, on one hand, the electronic component 320 may be shielded and protected with the shielding film 340, so that space waste of the circuit board assembly in the Z-direction can be reduced, thereby facilitating miniaturization and lightness of the terminal device. In addition, the shielding film 340 is thinner (the shielding cover 11 needs to be thickened to maintain a relatively wide shape because the shielding cover 11 cannot be attached), and a space occupied in the Z direction is smaller and has a weight gain, which facilitates lightening and miniaturization of the entire device.

In some embodiments of this application, referring to FIG. 5, a ground terminal 370 is disposed on a surface of the PCB 310. For example, the ground terminal 370 may be the ground pad 370 shown in FIG. 5. In a subsequent embodiment, the ground terminal 370 is used as the ground pad 370 as an example for description. The ground pad 370 is distributed on a side facing the side of the electronic component 320.

With reference to FIG. 5 and FIG. 7, FIG. 7 is a schematic diagram of a positional relationship between the insulation film 330 and the ground pad 370 in FIG. 5. The insulation film 330 further extends along the PCB 310 surface to the ground pad 370 along the bottom of the component body 321. A ground area is reserved on the surface of the ground pad 370. The width A of the grounding area is 0.1 mm~0.5 mm, and the grounding resistance of the grounding pad 370 is 101 mΩ~100 mΩ. For example, the width A of the ground area may be 0.1 µm, 0.2 µm, 0.3 µm, 0.4 µm, or 0.5 µm. The grounding resistance can be 10 mΩ, 20 mΩ, 34 mΩ, 55 mΩ, 75 mΩ, 84 mΩ, or 100 mΩ.

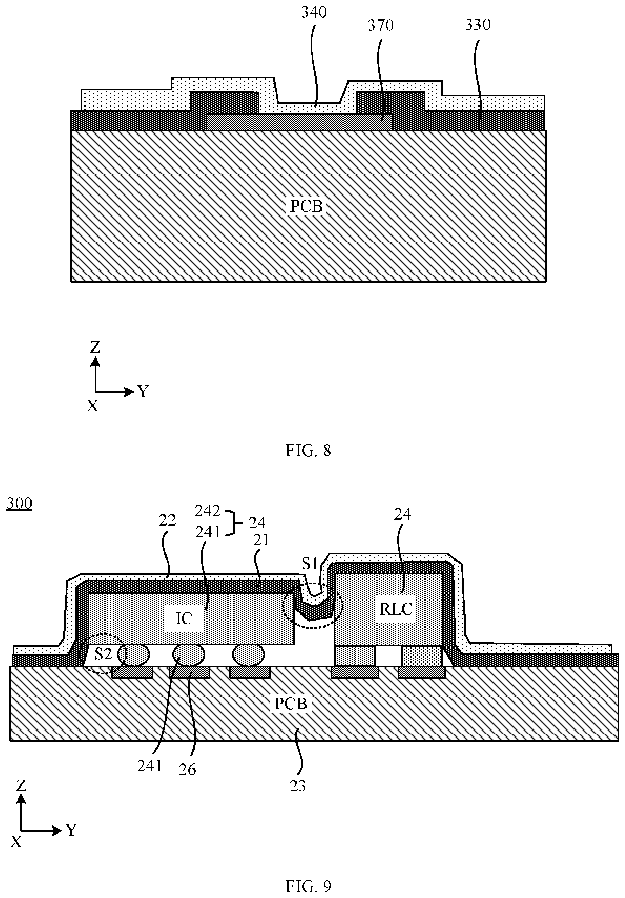

In this way, referring to FIG. 8, FIG. 8 is a schematic diagram of a positional relationship between a shielding film 340, an insulation film 330, and a ground pad 370 in FIG. 5. The shielding film 340 further extends along a surface of the insulation film 330 to the ground pad 370, and is electrically connected to the ground pad 370, so that a current accumulated on the shielding film 340 is released by using the ground pad 370, thereby playing an electromagnetic shielding role. Specifically, the shielding film 340 extends to a ground area of the ground pad 370, and is bonded to the ground area of the ground pad 370 to form an electrical connection to the ground pad 370.

It should be noted that, in FIG. 3, the shielding cover 11 is electrically connected to the ground pad 121 by using a Surface Mounted Technology (Surface Mounted Technology, SMT) welding process. In the SMT process, the shielding cover 11 is placed with a tolerance, an appearance, and other tolerances, so that a width of the ground pad 121 is not small. In this embodiment, the shielding film 340 is electrically connected by attaching to the ground pad 370, and there is no placement and appearance tolerance of the shielding cover 11 in FIG. 1. Therefore, a required width A of a ground area is smaller, so that a width (such as a pad width) of the ground pad 370 may be smaller, so that the circuit board assembly has a layout area benefit, which facilitates miniaturization of the whole unit.

The insulation film 330 extends to the ground pad 370, and the shielding film 340 extends to the ground pad 370 along the surface of the insulation film 330. Apparently, the shielding film 340 is located in a region between the ground pad 370 and the electronic component 320 and is isolated from each other by using a relatively thin insulation film 330 and the electronic component 320. Therefore, the ground pad 370 does not need to be disposed with a relatively wide avoidance width M2 shown in FIG. 3 to avoid the electronic component 320. Compared with the conventional solution shown in FIG. 3, the circuit board assembly has an area distribution benefit, which is conducive to miniaturization.

Optionally, referring to FIG. 5, to obtain more layout area gains, and further facilitate overall miniaturization, FIG. 5 shows a case in which a row of ground pads 370 is distributed between two adjacent electronic components 320 (that is, the first electronic component 320a and the second electronic component 320b) that need to be isolated. A row of ground pads 370 refers to multiple ground pads 370 arranged in a row.

The shielding film 340 may be electrically connected to the row of ground pads 370 to form a first shielding cavity covering the first electronic component 320a and a second shielding cavity covering the second electronic component 320b.

It may be understood that the shielding cover 11 in FIG. 3 is an integrated structure component, and is disposed on the PCB 310 in a manner of being fixed to the pad, to form a shielding cavity. When the two shielding covers 11 are used to isolate the two adjacent electronic components 13 that need to be isolated, two rows of ground pads 121 need to be disposed between the two adjacent electronic components 13, so as to separately fasten the two shielding covers 11 to the PCB 12, to form two shielding cavity bodies used to isolate the two electronic components 13.

In the circuit board assembly shown in FIG. 5, because the shielding film 340 is attached and molded, the shielding film 340 does not need to be disposed on the PCB 310 in a manner of being fastened to the pad. In this case, a problem of how to isolate the two electronic components 320 needs to be considered. In FIG. 5, the shielding film 340 may be electrically connected to a row of ground pads 370 between the first electronic component 320a and the second electronic component 320b, so as to be separated into two shielding cavity bodies configured to separately cover the first electronic component 320a and the second electronic component 320b. It can be learned that, compared with the conventional shielding solution shown in FIG. 3, the circuit board assembly 300 may be provided with only one row of ground pads 370 between the two adjacent electronic components 320 that need to be isolated, so as to have a layout area benefit and facilitate miniaturization of the whole unit.

The foregoing content describes a difference between the new board-level shielding integration solution shown in FIG. 5 and the conventional shielding solution shown in FIG. 3. With reference to FIG. 9 to FIG. 18, the following compares a difference between a circuit board assembly formed by the board-level film shielding solution shown in FIG. 4 and a circuit board assembly in FIG. 5.

Difference 1: Compared with a circuit board assembly formed by the board-level film shielding solution shown in FIG. 4, the insulation film 330 in the circuit board assembly shown in FIG. 5 may extend to a gap around the component body 321, and cover the electronic component 320.

Specifically, referring to FIG. 9, FIG. 9 is a schematic diagram of filling of a film material of a circuit board assembly 20 formed by the board-level film shielding solution shown in FIG. 4.

Because the electronic component 24 on the PCB 23 has a complex environment, a large height difference (for example, an IC height is low and an RLC height is high), and a layout density is high (a minimum spacing is 0.1 mm), a semi-curable insulation film 21 and a shielding film 22 are hot pressed, which needs to be considered for film stretching, fluidity, and strength. Therefore, a small gap (a small gap between devices shown in an area S1 shown in the figure and a small gap at a bottom of a device shown in an area S2 shown in the figure) of the circuit board assembly 20 is different from each other (a surface that cannot be attached to a small gap around the electronic component 24), and even a case in which the electronic component 24 cannot extend into a small gap around the component, so that the electronic component 24 cannot be overlaid.

It may be understood that, when the insulation film 21 is poorly filled in a small gap around the device, the insulation film 21 is easily peeled off from a surface of the electronic component 24 due to factors such as thermal expansion and cold shrinkage, thereby causing a reliability problem in an application environment such as peeling delamination and film material rupture. It should be noted that the shielding film 22 has relatively strong adhesion to each other due to factors such as a material (both the shielding film 22 and the insulation film 21 are high-molecular materials, and the electronic component 24 may be silicon-containing materials), a contact area, and the like, and does not easily peel off the surface of the insulation film 21.

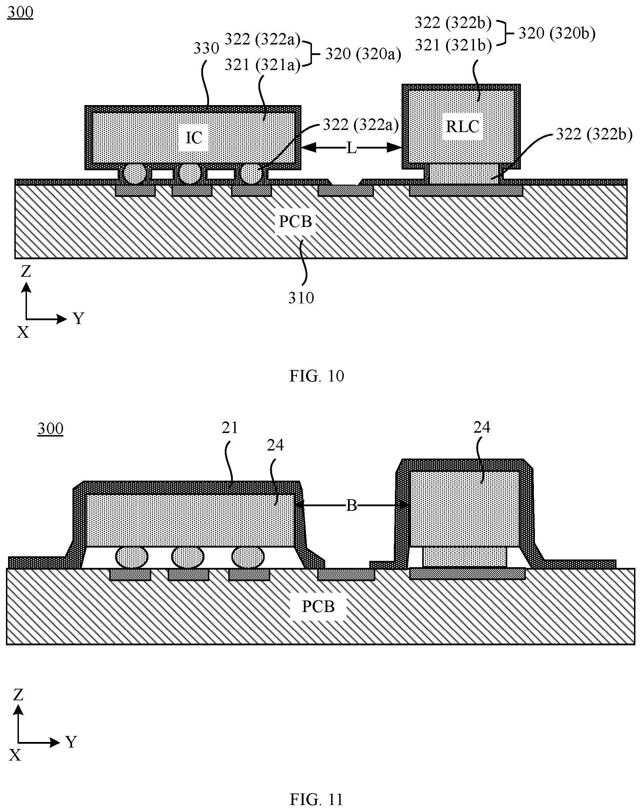

For a case in which the insulation film 21 is poorly filled in a small gap between devices in FIG. 9, refer to FIG. 10. FIG. 10 is a schematic diagram of a structure of a related insulation film 330 in the circuit board assembly shown in FIG. 5. An insulation film 330 is shown filled in a gap between electronic components 320. The insulation film 330 may extend into a gap between the electronic components 320, and extend along a side surface of the gap corresponding to the electronic component 320 to a bottom surface of the component body 321 of the electronic component 320, so that at least the component body 321 of the electronic component 320 is separately coated.

FIG. 10 shows two adjacent electronic components 320, which are respectively a first electronic component 320a and a second electronic component 320b. The following uses a gap between the first electronic component 320a and the second electronic component 320b as an example for detailed description.

Optionally, a width L of a gap between the first electronic component 320a and the second electronic component 320b is 1 µm~50 µm. In this case, it may be considered that there is a small gap between the first electronic component 320a and the second electronic component 320b.

The insulation film 330 may extend into a gap between the first electronic component 320a and the second electronic component 320b, and extend to a bottom surface of the component body (subsequently referred to as the first component body 321a) of the first electronic component 320a and a bottom surface of the component body (subsequently referred to as the second component body 321b) of the second electronic component 320b along a side surface of the gap corresponding to the first electronic component 320a and the second electronic component 320b, so as to separately coat the first electronic component 320a and the second electronic component 320b.

It should be noted that the first electronic component 320a and the second electronic component 320b are corresponding to a side surface of a gap, that is, the first electronic component 320a and the second electronic component 320b are opposite to each other.

In this embodiment, because the insulation film 330 extends along a side of a gap corresponding to the first electronic component 320a and the second electronic component 320b to a bottom surface of the first component body 321a and the second component body 321b, an attachment area is larger, and a gap between two adjacent electronic components 320 is better filled.

In addition, the insulation film 330 extends to the bottom surface of the first component body 321a and the bottom surface of the second component body 321b on the sides of the gap corresponding to the first electronic component 320a and the second electronic component 320b. Therefore, the insulation film 330 is bound to the side surface of the gap corresponding to the first electronic component 320a and the second electronic component 320b and to the bottom surface of the first electronic component 320a and the second electronic component 320b. A stronger pull force may be formed between the first electronic component 320a and the second electronic component 320b by attaching to a side surface and a bottom surface of a gap corresponding to the first electronic component 320a and the second electronic component 320b. An insulation film 330 is applied to cover a large area of attachment of the entire first electronic component 320a and the second electronic component 320b, so that the insulation film 330 can be more firmly attached to the surfaces of the first electronic component 320a and the second electronic component 320b without easy occurrence of reliability problems such as peeling and membrane cracking, and therefore, reliability of the circuit board assembly 300 in an application environment is improved.

Certainly, in some other embodiments, the insulation film 330 may also separately cover the first component body 321a and the second component body 321b without covering the connection end 322b of the first electronic component 320a and the connection end 322b of the second electronic component 320b. That is, in a specific implementation process, the insulation film 330 is configured to separately cover at least the first component body 321a and the second component body 321b. This is not specially limited in this embodiment of this application.

It should be noted that in a film plating process, a thin film material is converted into a gaseous atom, a molecule, or an ion, and deposited on a surface of the electronic component 320, so that the thin film material has a relatively low requirement for a gap around the component and has a relatively strong penetration effect. The insulation film 330 formed by pressing the thin film material without considering film material stretching, fluidity, and strength may extend to a small gap between the first electronic component 320a and the second electronic component 320b, and has a relatively good filling capability in the small gap between the components, thereby reducing a risk of delamination and rupture of the insulation film 330.

On the contrary, it may be understood that the insulation film 330 formed by the coating process has good filling in a small gap between devices, and therefore, the coating process requires a lower gap between two adjacent electronic components 320 that need to be isolated.

Referring to FIG. 11, FIG. 11 is a schematic diagram of a gap required by the insulation film 21 in the circuit board assembly 20 formed by the board-level film shielding solution shown in FIG. 4. In the embodiment shown in FIG. 11, the insulation film 21 is formed by a hot pressing process. To fill the insulation film 21 formed by the hot pressing process between the electronic components 24, it is required that a width B of a gap between the electronic components 24 is at least 0.5 mm, so that the insulation film 21 can be better filled between the electronic components 24, which is not conducive to a high-density miniaturization design of the PCB. In the embodiment shown in FIG. 10, a requirement of a coating process on a gap between devices is relatively low. For example, the coating process may implement better filling in a small gap between devices whose gap width is 1 µm~50 µm, which is conducive to a high-density miniaturization design of the PCB 310.

Certainly, in some other embodiments, if another process may enable the insulation film 330 to extend along a surface of the electronic component 320 to a small gap between two adjacent electronic components 320 that need to be isolated, complete attachment is also within the protection scope of this embodiment of this application.

For a case in which the insulation film 21 is poorly filled in a small gap at the bottom of the component in FIG. 9, refer to FIG. 10. FIG. 10 shows a case in which the insulation film 330 is filled in a gap at the bottom of the electronic component 320.

The insulation film 330 formed by the coating process may extend along a surface of the electronic component 320 to a bottom surface of the component body 321, so that a gap at the bottom of the electronic component 320 can be filled.

It should be noted that, in a film plating process, a thin film material is converted into a gaseous atom, molecule, or ion, and deposited on a surface of the electronic component 320, and therefore, the thin film material has a low requirement for a gap around the component and has a relatively strong penetration action. In addition, the thin film material is not compressed without considering film material stretching, fluidity, and strength, and the formed insulation film 330 is more easily coated with a bottom surface of the component body 321 of the electronic component 320, and has a relatively good filling property at a small gap at the bottom of the component.

Certainly, in some other embodiments, if another process may cause the insulation film 330 to extend along the surface of the electronic component 320 to the bottom surface of the component body 321, at least the component body 321 of the electronic component 320 is coated, which is also within the protection scope of the embodiments of this application.

It may be understood that the insulation film 330 extends along the surface of the electronic component 320 to the bottom surface of the component body 321, so that the electronic component 320 is coated, which is bound to the side surface of the electronic component 320 and the bottom surface of the electronic component 320. A stronger pull-off force may be formed between a part attached to a side surface and a bottom surface of the electronic component 320 and the electronic component 320, and an insulation film 330 is applied to cover a large adhesion area of the entire electronic component 320, so that the insulation film 330 can be more firmly attached to the surface of the electronic component 320 without a reliability problem such as delamination and film material rupture, thereby improving reliability of the circuit board assembly 300 in an application environment.

The following describes requirements of a coating process on a gap at a bottom of a component for different types of electronic components 320.

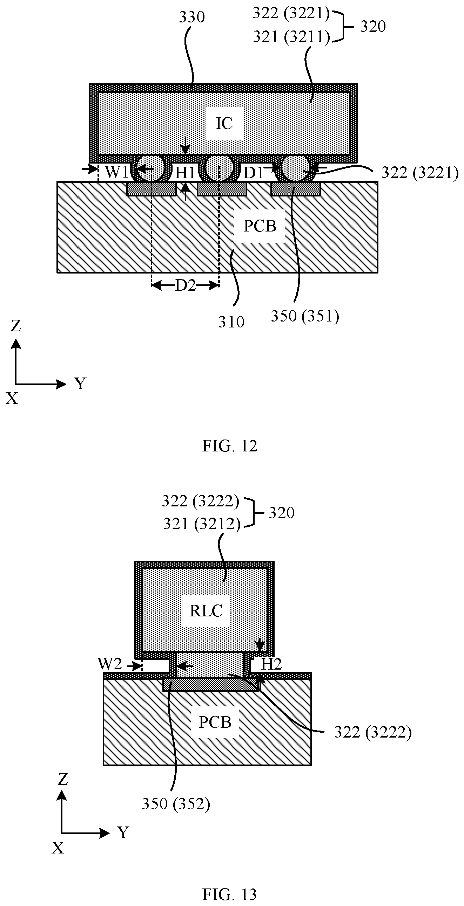

For example, referring to FIG. 12, FIG. 12 is a schematic diagram of a related structure of an insulation film 330 encapsulating a chip in the circuit board assembly shown in FIG. 5.

In the embodiment shown in FIG. 12, the electronic component 320 is a chip IC. For ease of distinction and description, in this application, the component body 321 of the IC is referred to as a chip body 3211, and the chip body 3211 is electrically connected to the component pad 350 on the PCB 310 by using the connection end 322 at the bottom of the chip body 3211. In this application, a connection end 322 at a bottom of a chip body 3211 is referred to as a chip solder end 3221, and a component pad 350 that is on the PCB 310 and that is electrically connected to the chip is referred to as a chip pad 351. That is, the chip body 3211 is electrically connected to the chip pad 351 on the PCB 310 by using the plurality of chip solder ends 3221 at the bottom of the chip body 3211.

When the IC meets at least one of the following four conditions, the IC may be considered as an electronic component 320 with a small gap at the bottom of the component. For such an IC, the insulation film 330 may be extended on the IC surface to a bottom surface of the chip body 3211 by using a coating process, so as to cover the IC, so as to implement good filling of a small gap at the bottom of the chip.

Condition 1: A bottom gap H1 of the chip meets 10 µm≤H1≤150 µm.

Condition 2: A recessed dimension of the chip solder end 3221 meets W1≥100 µm.

Condition 3: A diameter D1 of the chip solder end 3221 meets 150 µm≤D1≤300 µm.

Condition 4: A center distance D2 between two adjacent chip solder ends 3221 meets 300 µm≤D2≤600 µm.

It may be understood that the bottom gap H1 of the chip refers to a distance between the bottom surface of the chip body 3211 and the upper surface of the PCB 310. An indent size W1 of the chip solder end 3221 refers to a shortest distance between a plane on a side surface of the chip body 3211 and a surface of the chip solder end 3221. The center distance D2 of the two adjacent chip solder ends 3221 is a distance between the centers of the two adjacent chip solder ends 3221.

It may be understood that FIG. 12 is a case in which the chip terminal 3221 is used as the solder ball. In another embodiment, when the chip solder end 3221 is not a solder ball, the foregoing condition 3 is that a height D1 of the chip solder end 3221 in a Z-axis direction meets 150 µm≤D1≤300 u. The foregoing condition 4 indicates a distance between geometric centers of two adjacent chip solder ends 3221.

Certainly, in some other embodiments, when the chip meets at least one of the foregoing conditions 1 to 4, if another technology can enable the insulation film 330 to extend along the chip surface to the bottom surface of the chip body 3211, so as to implement good filling of the small gap at the bottom of the chip, the chip is also within the protection scope of this embodiment of this application.

For example, referring to FIG. 13, FIG. 13 is a schematic diagram of a structure of a related insulation film 330 encapsulating a passive element in the circuit board assembly shown in FIG. 5.

In the embodiment shown in FIG. 13, the electronic component 320 is a passive element RLC, such as a resistor (R) and an inductor (L) capacitor (C). For ease of distinction and description, the component body 321 of the RLC is referred to as an element body 3212 in this application. The component body 3212 is electrically connected to the corresponding component pad 350 on the PCB 310 by using the connection end 322 at the bottom of the component body 3212. In this application, the connection end 322 at the bottom of the component body 3212 is referred to as the element solder end 3222, and the component solder pad 350 electrically connected to the RLC on the PCB 310 is referred to as the component solder pad 352. That is, the component body 3212 is electrically connected to the component pad 352 on the PCB 310 by using the element solder end 3222 at the bottom of the component body 3212.

When the electronic component 320 is an RLC, the electronic component 320 may be considered as an electronic component 320 having a small gap at the bottom of the component when the bottom gap H2≤30 µm (condition 1) of the RLC and/or the element solder end 3222 of the RLC is indent size W2≥30 µm (condition 2). For this type of RLC, the insulation film 330 may be extended on the surface of the passive element to the bottom surface of the element body 3212 by using a coating process, so as to implement good filling of the small gap at the bottom of the passive element.

It may be understood that the bottom gap H2 of the passive element refers to a spacing between the bottom surface of the element body 3212 and the upper surface of the PCB 310. The indent size W2 of the component welded end 3222 refers to the shortest spacing between the plane on the side of the component body 3212 and the surface of the component welded end 3222.

Certainly, in some other embodiments, when the passive element meets the foregoing condition 1 and/or the foregoing condition 2, if another process may cause the insulation film 330 to extend along the surface of the passive element to the bottom surface of the element body 3212, to implement good filling of the small gap at the bottom of the passive element, it is also within the protection scope of this embodiment of this application.

Difference 2: Compared with the circuit board assembly formed by the board-level film shielding solution shown in FIG. 4, the insulation film 330 in the circuit board assembly 300 shown in FIG. 5 may be attached to the surface of the connection end 322.

Specifically, referring to FIG. 9, the insulation film 21 is poorly filled in a small gap at the bottom of the component, so that the insulation film 21 cannot extend to the surface of the component solder ball 242 located at the bottom of the component body 241, so that a short circuit may easily occur between the solder joints (a structure formed by the component solder ball 242 and the component solder pad 26) of the electronic component 24.

For an electrical failure problem that may be caused by a short circuit between solder joints in FIG. 9, continue to refer to FIG. 10. The insulation film 330 extends from a bottom surface of the component body 321 to a surface of the connection end 322, and covers the connection end 322 together, thereby implementing coating of the entire electronic component 320. It may be understood that, in this embodiment, the insulation film 330 covers the connection end 322. In one aspect, the insulation film 330 may serve as a base glue filling function and disperse stress of the connection end 322, thereby improving electrical connection reliability. In another aspect, the connection end 322 may be insulated from the outside, so as to reduce a risk of a short circuit between solder joints.

It should be noted that the insulation film 330 formed by the coating process may extend to a bottom of the component body 321, and naturally may also extend to a surface of the connection end 322 located at the bottom of the component body 321, so as to implement coating of the connection end 322 at the bottom of the component. Certainly, in some other embodiments, if another process may cause the insulation film 330 to extend along the surface of the electronic component 320 to the surface of the connection end 322 at the bottom of the component body 321, the insulation film 330 also falls within the protection scope of the embodiments of this application.

Difference 3: The insulation film 330 in the circuit board assembly shown in FIG. 5 has better adhesion at a recess position on a surface of the component than the circuit board assembly formed by the board-level film shielding solution shown in FIG. 4.

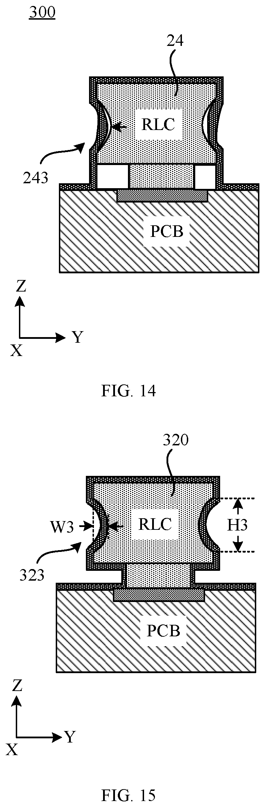

Specifically, referring to FIG. 14, FIG. 14 is a schematic diagram of a concave position of the insulation film 21 on a surface of a component in a circuit board assembly 20 formed by the board-level film shielding solution shown in FIG. 4.

In FIG. 14, the electronic component 24 is a special recess component, that is, an electronic component 24 that has a recessed surface 243. When the semi-cured insulation film 21 is crimped, the insulation film 21 is not securely attached to the depression area 243 due to a factor such as a small pressure of the insulation film 21 (because an inner wall surface of a concave position of a surface of a special recess component is lower than a surrounding surface), and is prone to peeling and delamination due to a factor such as thermal expansion and cold shrinkage.

For a case in which the electronic component 24 in FIG. 14 is a special recess component, for example, referring to FIG. 15, FIG. 15 is a schematic diagram of a structure of a circuit board assembly that is shown in FIG. 5 and in which an insulation film 330 is used to cover the special recess component 320.

In the embodiment shown in FIG. 15, the electronic component 320 is a special recess component 320. It may be understood that, although the special recess component 320 in the figure is a passive element RLC, in another embodiment, the special recess component 320 may also be an active component.

A surface of the special recess component 320 has a groove 323, and a position in which the groove 323 is located is a recessed position of the surface of the special recess component. The insulation film 330 formed by the coating process extends along the surface of the special recess component to the groove 323, and is attached to the inner wall surface of the groove 323. It may be understood that, because a film plating process does not involve hot pressing a film material by using a pressure, and instead, the insulation film 330 is formed in a deposition manner, a case in which the insulation film 21 is not securely attached to an inner wall surface of the groove 323 due to a small pressure, and a case in which the insulation film 21 is peeled and delaminated does not easily occur.

In a specific implementation process, when the groove width H3 of the groove 323 meets 100 µm≤H3≤700 µm (condition 1) and/or the groove depth W3≥20 µm (condition 2) of the groove, the insulation film 330 may be extended along the surface of the special recess component to the groove by using a coating process, and the insulation film 330 is attached along the inner wall surface of the groove, so that the insulation film 330 is covered with the special recess component 320.

Certainly, in some other embodiments, when the special recess component 320 meets the foregoing condition 1 and/or the foregoing condition 2, if another process may cause the insulation film 330 to attach to the inner wall surface of the groove 323, the insulation film 330 is also within the protection scope of the embodiments of this application.

Difference 4: Compared with the circuit board assembly formed by the board-level film shielding solution shown in FIG. 4, the insulation film 330 in the circuit board assembly shown in FIG. 5 is more uniform in thickness, which facilitates electrical consistency design.

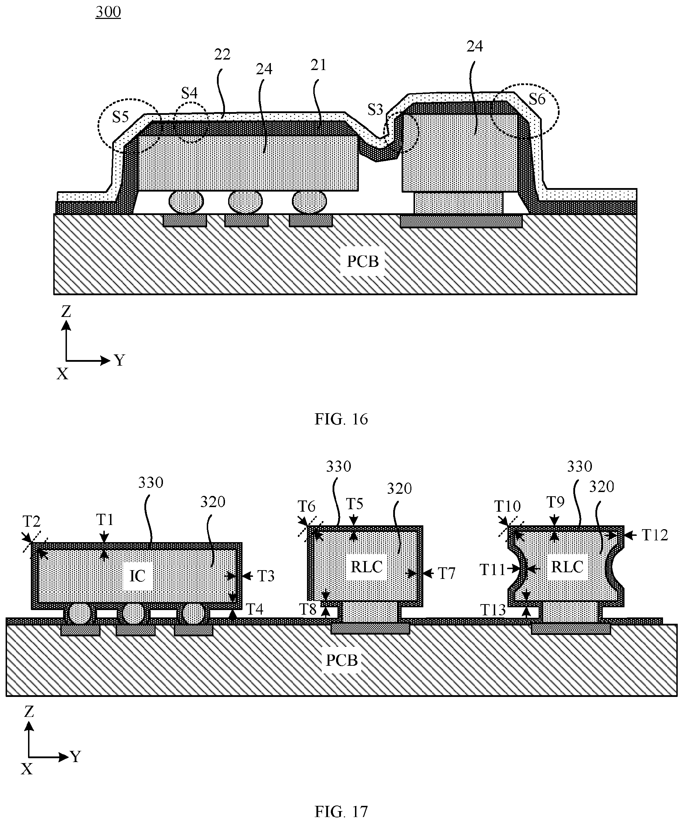

Specifically, referring to FIG. 16, FIG. 16 is a schematic diagram of a thickness uniformity problem and a short-circuit risk that exist in the circuit board assembly 20 formed by the board-level film shielding solution shown in FIG. 4.

In FIG. 16, the insulation film 21 is formed by using a hot pressing process. It should be noted that a film thickness formed by using a hot pressing process is strongly correlated with a height and layout density of the electronic component 24. For example, a thickness of a position shown in a region S3 in FIG. 1 is relatively different from a thickness of a position shown in a region S4, so that a thickness of the insulation film 21 is relatively different (a thickness difference of different positions exceeds 30 µm).

It may be understood that distribution of the shielding film 22 and the electronic component 24 is equivalent to forming one capacitor, the shielding film 22 and the electronic component 24 are respectively two electrode plates of the capacitor, and a thickness of the insulation film 21 between the shielding film 22 and the electronic component 24 is different, so that a spacing between the two electrode plates of the capacitor is inconsistent. The parasitic capacitance of the capacitor is related to the spacing between the two electrode plates. A thickness difference of the insulation film 21 at different positions is too large, so that a parasitic capacitance difference of the insulation film 21 at different positions is too large. It should be noted that a problem such as frequency drift due to a parasitic capacitor exists. A parasitic capacitance difference of different positions is too large, so that a frequency drift difference of different positions is too large, which is not conducive to electrical consistency design.

Referring to FIG. 17, FIG. 17 is a schematic diagram of a structure of a circuit board assembly shown in FIG. 5 that involves a thickness of an insulation film 330.

In FIG. 17, because the insulation film 330 is formed in a manner of depositing a film material by using a film plating process, pressing and stretching of the film material by using a hot pressing process is not involved, and a film thickness of the insulation film 330 is not strongly correlated with a height and layout density of the electronic component 320. Therefore, the thickness of the insulation film 330 is more uniform.

The thickness difference indicator T≤10% of the insulation film 330 is tested. T=(Ta-Tb)/Ta, and Ta and Tb are thicknesses at any two positions of the insulation film 330.

For example, FIG. 17 shows a thickness of the insulation film 330 at different positions on a surface of three components: A chip IC, a passive element RLC, and a special recess component RLC. For the insulation film 330 on the IC surface, Ta and Tb may be any two positions in multiple positions shown in FIG. T1 (a schematic position is a position of the insulation film 330 corresponding to an IC top surface), T2 (a schematic position is a position of the insulation film 330 corresponding to an IC tip angle), T3 (a schematic position is a position of the insulation film 330 corresponding to an IC side surface), and T4 (a schematic position is a position of the insulation film 330 corresponding to an IC bottom surface). For the insulation film 330 on the RLC surface of the passive element, Ta and Tb may be any two positions in multiple positions shown in FIG. T4 (a schematic position is a position of the insulation film 330 corresponding to the RLC top surface of the passive element), T5 (a schematic position is a position of the insulation film 330 corresponding to the RLC top surface of the passive element), T6 (a schematic position is a position of the insulation film 330 corresponding to the RLC tip angle of the passive element), T7 (a schematic position of the insulation film 330 corresponding to the RLC side surface of the passive element), and T8 (a schematic position is a position of the RLC bottom surface of the passive element corresponding to the insulation film 330). For the insulation film 330 on the RLC surface of the special recess component, Ta and Tb may be any two positions in multiple positions shown in FIG. T9 (a schematic position is a position of an insulation film 330 corresponding to an RLC top surface of the special recess component), T10 (a schematic position is a position of an RLC tip angle of the special recess component corresponding to the insulation film 330), T11 (a schematic position is a position of an RLC groove of the special recess component corresponding to the insulation film 330), T12 (a schematic position is a position of an RLC side surface of the special recess component corresponding to the insulation film 330), and T13 (a schematic position is a position of an RLC bottom surface of the special recess component corresponding to the insulation film 330).

It should be noted that the thickness difference indicator T is used to represent thickness consistency of the insulation film 330. A higher thickness difference indicator T indicates a higher thickness consistency of the insulation film 330. The lower the thickness difference indicator T, the lower the thickness consistency of the insulation film 330. It may be understood that a higher thickness consistency of the insulation film 330 represents a more uniform thickness of the insulation film 330.

In FIG. 16, a thickness of the insulation film 21 formed by using a hot pressing process is generally 50 µm~150 µm. When a thickness difference of different positions exceeds 30 µm, a thickness difference indicator T of the insulation film 21 is 20%. Apparently, the insulation film 330 shown in FIG. 17 has better uniformity of thickness at each position of the electronic component, and is more uniform in thickness, which facilitates electrical consistency design.

Difference 5: The insulation film 330 in the circuit board assembly 300 shown in FIG. 5 is thinner than the circuit board assembly obtained by using the board-level film shielding solution shown in FIG. 4.

Referring to FIG. 16, a thickness of a film formed by a hot pressing process is strongly correlated with a height and a layout density of an electronic component. For example, a position with a relatively large component height difference is thinner (for example, a position indicated by a region S3), and a position with a relatively small component height difference (for example, a position indicated by a region S4) is thicker. It may be understood that, to reduce a risk of a film material rupture, a thickness of a film layer formed by a hot pressing process also needs to reach a standard at a thinnest position. In this case, a thickness of a film layer at another position is too thick to implement ultra-thin, or otherwise, a tensile rupture risk may occur. According to a test, a thickness of an insulation film formed by a hot pressing process is generally 50 µm~150 µm. For example, a thickness of a position shown in a region S3 is 80 µm, and a thickness of a position shown in a region S3 is 130 µm. Apparently, the insulation film 330 and the shielding film 340 formed by the hot pressing process cannot be ultra-thin, which is not conducive to a reduction of a circuit board assembly.

However, in the embodiment shown in FIG. 17, an insulation film 330 formed by a film plating process has a uniform thickness, and does not need to be intentionally thickened to prevent a film thickness from being broken at a thinnest position. A film thickness of an external nanoscale to micron level can be implemented. Therefore, when the insulation film 330 is formed by a film plating process, the insulation film 330 may be ultra-thin, thereby facilitating overall thinning of a circuit board assembly. In addition, it may be understood that, because the coating process may make the insulation film 330 ultra-thin, and reserve more space for the shielding film 340, in the circuit board assembly shown in FIG. 5, even by using a hot pressing process, the shielding film 340 is better filled between a device bottom and a device.

Optionally, a thickness at any position of the insulation film 330 formed by the coating process may be 0.5 µm~40 µm. A thickness interval of 0.5 µm~40 µm makes it difficult to risk a short-circuit between the shielding film 340 and the electronic component 320, and is thinner than an insulation film formed by a hot pressing process, and has a thickness gain.

It should be noted that a thickness range of 0.5 µm~40 µm is intended to indicate an order of the thickness of the insulation film 330 formed by the coating process, and does not indicate that a thickness of the insulation film 330 formed by the coating process at different positions is 0.5 µm~40 µm, which is a relatively different value in the thickness range.

With reference to the foregoing content, it may be learned that the insulation films 330 formed by a film plating process on a same circuit board assembly have different thicknesses at different positions, but a thickness difference is relatively small, and a thickness difference indicator T≤10%. For example, the thickness of the insulation films 330 in FIG. 17 are respectively 20.5 µm, 20 µm, 20.1 µm, 20.4 µm, and 20.3 µm, but fall in a thickness area of 0.5 µm~40 µm. A thickness of the insulation film 330 formed by the coating process on different circuit board assemblies may vary greatly. For example, a thickness of the insulation film 330 formed by the coating process on some circuit board assemblies is 39 µm~40 µm, and falls within a thickness area of 0.5 µm~40 µm. A thickness of the insulation film 330 formed by the coating process on some circuit board assemblies is 25 µm~26.7 µm, and falls within a thickness area of 0.5 µm~40 µm.

Difference 6: Compared with the circuit board assembly obtained by using the board-level film shielding solution shown in FIG. 4, the shielding film 340 in the circuit board assembly shown in FIG. 5 and the electronic component 320 are not susceptible to a short-circuit risk.

Specifically, referring to FIG. 16, because the electronic component 24 on the PCB 23 has a complex environment and a large drop difference (a maximum of 1.2mm and a minimum of 0.2mm), a relatively large tensile deformation occurs in the insulation film 21 when the hot pressing process is used to compress and mold, so that the insulation film 21 of the insulation film 21 is thinned to penetrate at a sharp angle position of the electronic component 24 (for example, a region S5 and a region S6), so that there is a risk of a short circuit between the shielding film 22 and the electronic component 24, and electrical failure is easily caused.

For a problem that the insulation film 21 formed by the hot pressing process in FIG. 16 is thinned or even penetrated at a sharp angle position of the electronic component 24, continue to refer to FIG. 17. Because the insulation film 330 is formed by a coating process, stretching of the film material by the hot pressing process is not involved, and naturally, a high stretching rate is stretched at the sharp angle position of the electronic component 320. With reference to the foregoing content, it may be learned that a thickness difference indicator T≤10% of the insulation film 330. It can be seen that the thickness of the insulation film 330 is more uniform, and there is no obvious thinning or even penetration at a sharp angle position of the electronic component 320 (as shown in FIG. T2, FIG. T6, and FIG. T10). In this way, a short circuit does not occur between the shielding film 22 and the electronic component 24, and an electrical failure does not occur.

Difference 7: Compared with a circuit board assembly obtained by using the board-level film shielding solution shown in FIG. 4, the circuit board assembly 300 shown in FIG. 5 is not prone to a problem of a breakdown of the insulation film 330.

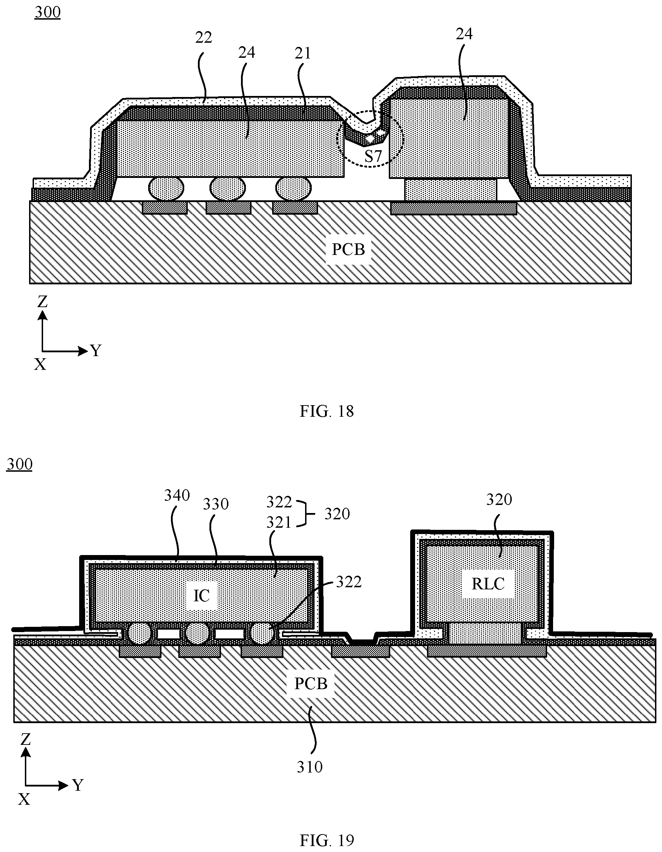

Specifically, referring to FIG. 18, FIG. 18 is a schematic diagram of a film material rupture problem existing in the circuit board assembly 20 obtained by using the board-level film shielding solution shown in FIG. 4.

Because the electronic component 24 on the PCB 23 has a complex environment and a large drop difference (a maximum of 1.2mm and a minimum of 0.2mm), a relatively large tensile deformation occurs when the film material is compressed by using a hot pressing process, causing a risk of rupture of the film material at a high tensile rate. The figure shows a case in which the insulation film 330 has a rupture of the film material (as shown in Figure S7). It may be understood that, when the insulation film 330 is broken, there is a risk of a short circuit between the shielding film 22 and the electronic component 24.

For a case in which the insulation film 21 formed by the hot pressing process in FIG. 18 is prone to rupture of the film, continue to refer to FIG. 17. Because the insulation film 330 is formed by using the film plating process, stretching of the film material by the hot pressing process is not involved, and a case in which the film is broken due to a large tensile rate is not easy to occur, so that a short circuit between the shielding film 22 and the electronic component 24 is not easy to occur, and an electrical failure is not easy to occur.

With reference to FIG. 5 to FIG. 18, a new board-level shielding integration solution of the insulation film 330 formed by using a film plating process and the shielding film 340 formed by using a hot pressing process and a board-level shielding solution of the shielding film 340 shown in FIG. 4 are compared and described.

It should be noted that, because the shielding film 340 in the circuit board assembly shown in FIG. 5 uses a hot pressing process, there are still a series of problems such as uniform thickness due to stretching, a film crack, and a relatively thick film. Based on this, based on the circuit board assembly shown in FIG. 5, an embodiment of this application further provides another circuit board assembly that uses a new board-level shielding integration solution.

Refer to FIG. 19. FIG. 19 is a schematic diagram of a structure of a circuit board assembly 300 according to some embodiments of this application. FIG. 19 may be understood as another sectional view of the circuit board assembly 300 shown in FIG. 2 on an X-ZY plane.

The circuit board assembly 300 shown in FIG. 19 also uses the foregoing new board-level shielding integration solution. In the circuit board assembly shown in FIG. 19, an insulation structure in the foregoing new board-level shielding integration solution is implemented by using an insulation film 330 formed by a coating process, and a shielding structure is implemented by using a coating process or a shielding film 340 formed by a printing process. The following mainly describes a shielding film 340 in which the PCB 310 shown in FIG. 19 and the circuit board assembly shown in FIG. 5 are different. Other content in FIG. 19 (for example, compared with a conventional shielding solution shown in FIG. 3 and a difference and a technical effect brought by the board-level film shielding solution shown in FIG. 4) may be adaptive to the related descriptions in FIG. 5 to FIG. 18.

Compared with the shielding film 340 formed by the hot pressing process in FIG. 5, in the circuit board assembly shown in FIG. 19, the shielding film 340 formed by the spraying process or the printing process is more easily extended into a small gap at the bottom of the component. As shown in FIG. 19, the shielding film 340 is attached to an area on a surface of the insulation film 330 that faces a side surface of the electronic component 320, extends to an area on a surface of the insulation film 330 that faces a non-connection area on a bottom surface of the component body 321, is attached to an area on a surface of the insulation film 330 that faces a non-connection area on a bottom surface of the component body 321, extends to an area on a surface of the insulation film 330 that faces an outer surface of the connection end 322, and is attached to and extends to a PCB 310.

The outer surface of the connection end 322 refers to a surface on which the connection end 322 faces the outer surface (a side facing the side of the component body 321). In this way, the shielding film 340 does not extend between the solder joints, thereby reducing the risk of short-circuiting the shielding film 340 between the two solder joints.

It should be noted that, compared with the shielding film 340 formed by the hot pressing process in FIG. 5, because the spraying process and the printing process do not involve compression of the film material and do not need to take account of film stretching and strength, the coating process and the printing process form the shielding film 340 through penetration of the film material into the gap. Therefore, the coating process and the printing process form the shielding film 340 more easily extends to a small gap at the bottom of the component body 321, and the spraying process and the printing process require a lower gap at the bottom of the device. It may be understood that, when the shielding film 340 extends to a small gap at the bottom of the device, the insulation film 330 may be bound from more regions, thereby reducing a risk of delamination of the inner insulation film 330 from the surface of the electronic component 320. When the shielding film 340 has a lower requirement for the gap at the bottom of the device, it is conducive to lightening and miniaturization of the whole unit.

In a specific implementation process, when the shielding film 340 is formed by using a spraying process or a printing process, the shielding material used by the shielding film 340 may be a flowing material having a conductive characteristic.

For example, the shielding material may be a flowing material that includes metal. For example, a conductive ink or a conductive adhesive. The conductive ink may be a pure metal solution, such as copper or silver. The conductive adhesive may be a mixture formed by mixing the resin and the metal particles. The resin may be epoxy resin, PBO, PI, Parylene, PET, PTFE, TPU, FEP, PFA, HDPE, or the like, and the metal particles may be any one of copper, nickel, chromium, aluminum, silver, gold, or a metal alloy. For example, the shielding material may further be a flowing material that includes a carbon material. The carbon material may be graphite, graphene, carbon nanotubes, or the like. For example, the shielding material may be a composite of a carbon material and an organic material, or may be a composite of a metal, a carbon material, and an organic material, so that the shielding material has fluidity.

Certainly, in some other embodiments, the shielding film 340 formed by the spraying process or the printing process may not extend to a bottom surface of the component body 321, which is not limited in this embodiment of this application.

Compared with the shielding film 340 formed by the hot pressing process in FIG. 5, in the circuit board assembly shown in FIG. 19, the shielding film 340 formed by the spraying process or the printing process extends more easily into the small gap between the devices. For a specific reason, refer to the foregoing reason that the shielding film 340 extends more easily into the small gap at the bottom of the device. It may be understood that, when the shielding film 340 extends into a small gap between devices, two adjacent electronic components 320 that need to be isolated may be separated, thereby reducing electromagnetic interference between the two electronic components 320.

Conversely, the shielding film 340 formed by the spraying process or the printing process requires less clearance between the two adjacent electronic components 320 that need to be isolated.

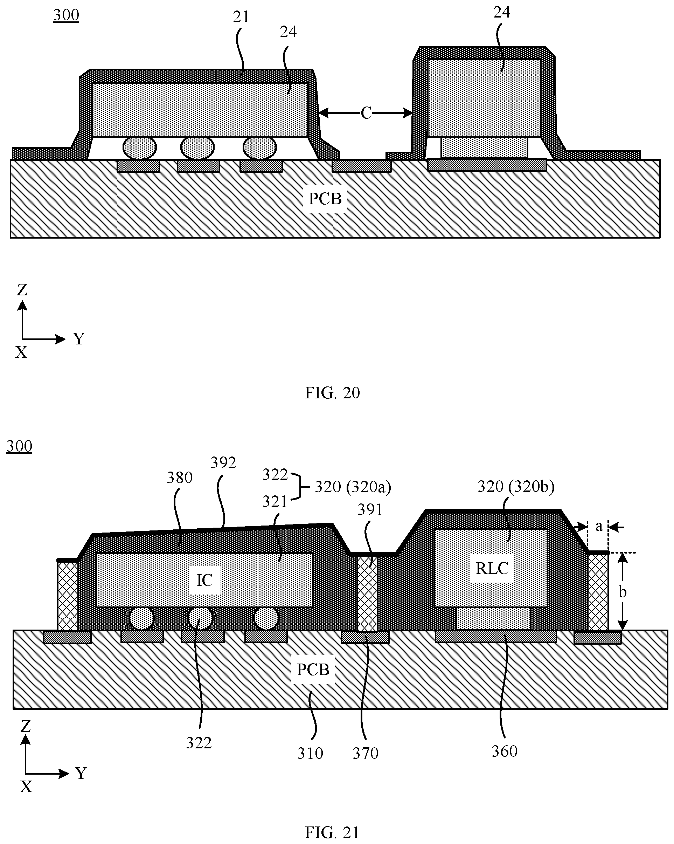

With reference to FIG. 20, FIG. 20 is a schematic diagram of a gap required by a shielding film in a circuit board assembly 20 formed by using the board-level coating shielding solution shown in FIG. 4. In the embodiment shown in FIG. 20, the shielding film 22 is formed by a hot pressing process. To fill the shielding film 22 formed by the hot pressing process between the electronic components 24, a width C of a gap between the electronic components 24 of the insulation film 21 is required to be at least 0.4 mm, so as to better fill the shielding film 22. Obviously, this is not conducive to the high-density miniaturization design of the PCB. However, in the embodiment shown in FIG. 19, compared with a hot pressing process, a requirement for a gap between the electronic components 320 is lower due to a spraying process or a printing process, thereby facilitating a high-density miniaturization design of the PCB 310.

Compared with the shielding film 340 formed by the hot pressing process in FIG. 5, in the circuit board assembly shown in FIG. 19, because the shielding film 340 is formed by spraying a film material with fluidity by using a spraying process or a printing process, pressing and stretching of the film material by the hot pressing process are not involved, and a film thickness of the insulation film 330 is not related to a height and a layout density of the electronic component 320. Therefore, a thickness of the shielding film 340 formed by the spraying process or the printing process is more uniform, and a thickness of the insulation film 340 does not need to be etched so that the film thickness is not easily broken at a thinnest position. In this case, the thickness of the shielding film formed by the spraying process or the printing process may be thinner, thereby facilitating overall thinning of the circuit board assembly.

Optionally, a thickness at any position of the shielding film 340 formed by the spraying process or the printing process may be 2 µm~40 µm. The thickness interval of the 2 µm~40 µm makes the shielding film 340 less susceptible to electromagnetic shielding leakage, and is thinner than the shielding film 340 formed by the hot pressing process, and has a thickness gain.

The thickness range of the 2 µm~40 µm is intended to describe an order of the thickness of the shielding film 340 formed by the spraying process or the printing process, and does not represent a value of a large difference in the thickness range of the shielding film 340 formed by the plating process or the printing process at different positions of the shielding film 340. It should be noted that a thickness of the shielding film 340 on the same circuit board assembly is different at different positions, but a thickness difference of the shielding film 340 on the same circuit board assembly is relatively small. For example, a thickness of the shielding film 340 on the same circuit board assembly on a top surface, a side surface, a tip angle, and a bottom surface of the electronic component 320 is respectively 20.7 um, 20.2 µm, 20.1 µm, and 20.4 µm. A thickness difference of the shielding film 340 on different circuit board assemblies may be relatively large. For example, a thickness of the shielding film 340 on some circuit board assemblies is 37 µm~40 µm, and a thickness of the shielding film 340 on some circuit board assemblies is 2 µm~4 µm.

Certainly, when performance of a tool used in the hot pressing process is improved, a shielding film 340 formed in the hot pressing process may also reach 2 µm~40 µm, but costs required are extremely high. Therefore, in a specific implementation process, the shielding film 340 is preferably formed by using a spraying process or a printing process. It should be noted that, because the thickness of the shielding film 340 is not strongly related to the parasitic capacitance, the circuit board assembly shown in FIG. 19 does not require uniformity of the thickness of the shielding film 340. Based on this, even though the thickness uniformity of the shielding film 340 formed by using the spraying process or the printing process in the circuit board assembly shown in FIG. 19 is not the same as that of the shielding film 340 formed by using the coating process, a requirement may be met.

Compared with the shielding film 340 formed by the hot pressing process in FIG. 5, in the circuit board assembly shown in FIG. 19, the shielding film 340 formed by the spraying process and the printing process is naturally stretched at a high tensile rate at a sharp-angle position of the electronic component 320 because the film material is not stretched. With reference to the foregoing content, it may be learned that a thickness of the shielding film 340 is more uniform, and a position such as a sharp angle position or a position with a relatively large component height difference does not appear to be significantly thinned or even broken. Therefore, a risk of shielding leakage in the circuit board assembly shown in FIG. 19 is lower.

Certainly, in some other embodiments, the shielding film 340 that has a same feature as the shielding film 340 formed by the foregoing spraying process or printing process may also be obtained by using another process. This is not limited in this embodiment of this application.

For example, another process may be a coating process. The shielding film 340 formed by the film plating process may extend to a small gap at the bottom of the component and a small gap between the components, and a requirement for a gap at the bottom of the component and a gap between the components is lower, and a film material is thinner and does not easily become thin and a film layer is broken. For a specific reason, reference may be made to the foregoing related description of forming an insulation film by using the film plating process. In this way, the shielding film 340 formed by the film plating process may have a shielding film 340 extending to a small gap at a bottom of the component and a small gap between the components, and a requirement for a gap at a bottom of the component and a gap between the components is lower, and a thin film material is not easily thinned or a film is broken. For details, refer to related descriptions of the shielding film 340 formed by the foregoing spraying process or printing process. Details are not described herein again.

In a specific implementation process, the coating process may be specifically a sputtering process. When the shielding film 340 is formed by using a sputtering process, a material of the shielding film 340 may be any one of copper, chromium, nickel, or a metal alloy.

Compared with forming the shielding film 340 by using a spraying process or a printing process, because the coating process relies on deposition growth of an atomic-grade material, a film material has a stronger penetration into a gap in a processing process, and therefore is more easily extended to a gap around the device. That is, it is easier to extend between solder joints. In this case, other means need to be introduced to prevent them from extending between solder joints. On the contrary, it may be understood that, compared with the coating process, the spraying process or the printing process depends on the fluidity of the material, which has a weaker penetration to the gap, and therefore does not easily extend to an area between the solder joints. In addition, the shielding film 340 formed by the coating process is more uniform and thinner than the coating process or the printing process.

In FIG. 5 to FIG. 20, in a new board-level shielding integration solution, an insulation structure is implemented by using an insulation film 330 attached with a type, and a shielding structure is implemented by using a shielding film 340 attached with a type.

In addition, an embodiment of this application further provides another circuit board assembly.

For example, referring to FIG. 21, FIG. 21 is a schematic diagram of a structure of another circuit board assembly according to an embodiment of this application. FIG. 21 may be understood as another cross-sectional view of the circuit board assembly 300 shown in FIG. 2 on an XY plane. The circuit board assembly 300 shown in FIG. 21 also uses the foregoing new board-level shielding integration solution. Therefore, filling at the bottom of the electronic component 320 can also be implemented.

Different from the foregoing circuit board assembly shown in FIG. 5, in the circuit board assembly shown in FIG. 21, the insulation structure in the foregoing new board-level shielding integration solution is implemented by using an insulation colloid 380, and the shielding structure is implemented by using a connected conductive frame (also referred to as a conductive dam in this embodiment of this application, which is subsequently described by using a conductive dam as an example) 391 and a shielding film 392. That is, the insulation structure is an insulation colloid 380, and the shielding structure includes a conductive dam 391 and a shielding film 392.

The conductive dam 391 is first described.

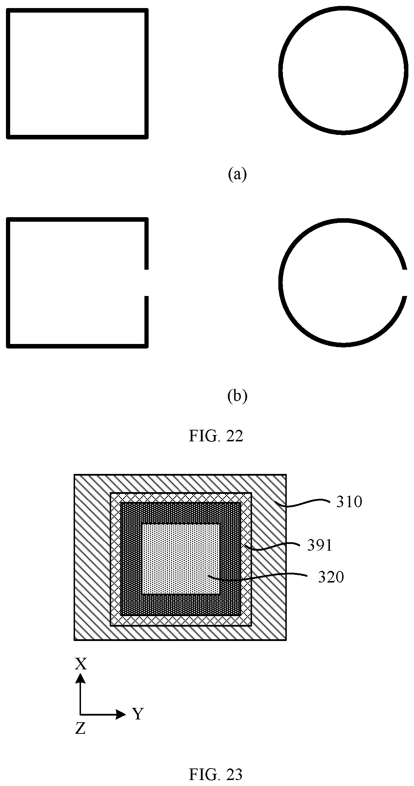

The conductive dam 391 is formed on a PCB 310 surface (that is, an upper surface shown in FIG. PCB 310) on a side on which the electronic component 320 is located, and surrounds a side facing the side on which the electronic component 320 is located. The technical term "circumference" in this embodiment of this application refers to that a ring structure forms a closed ring (a ring without a notch). FIG. 22 shows a non-closed ring without a notch (as shown in FIG. 22 (a)) and a closed ring with a notch (as shown in FIG. 22 (b)), so that a structure is located inside the closed ring and surrounds the ring. It should be noted that the ring structure is not limited to a ring structure (that is, the formed circumference ring is a closed ring). For example, the ring structure may be a square ring structure (that is, the formed circumference ring is a closed ring).

For example, referring to FIG. 23, FIG. 23 is a top view of the circuit board assembly 300 shown in FIG. 21. The figure shows a case in which the conductive dam 391 is a square ring structure, and an enclosed square ring formed by the conductive dam 391 of the square ring structure surrounds the electronic component 320 inside, so as to surround the electronic component 320.

In this embodiment, that the conductive dam 391 surrounds the side facing of the electronic component 320 indicates that the conductive dam 391 is located on the side facing of the electronic component 320, and the electronic component 320 is surrounded by the side facing of the side facing of the electronic component 320. In this case, as shown in FIG. 23, the projection of the electronic component 320 on the PCB 310 is located in the projection of the conductive dam 391 on the PCB 310. It may be understood that the conductive dam 391 and the electronic component 320 in the top view angle shown in FIG. 23 may be understood as projections on the PCB 310.

It should be noted that, when the conductive dam 391 surrounds the electronic component 320, a gap is maintained between the conductive dam 391 and a side surface of the electronic component 320, so that the insulation colloid 380 can be filled between the conductive dam 391 and the side surface of the electronic component 320, thereby providing an insulation effect.

In a specific implementation process, the conductive dam 391 may be formed on a surface of the PCB 310 by using a glue dispensing process, which is specifically formed on a surface of the ground pad 370 on the surface of the PCB 310. The material of the conductive dam 391 may be conductive adhesive. The conductive adhesive may be a mixture formed by mixing the resin and the metal particles. The resin may be epoxy resin, PBO, PI, Parylene, PET, PTFE, TPU, FEP, PFA, HDPE, or the like, and the metal particles may be any one of copper, nickel, chromium, aluminum, silver, gold, or a metal alloy. Certainly, in some other embodiments, the conductive dam 391 may also be formed by another process such as a spraying process.

Next, the insulation colloid 380 is described.

The insulation colloid 380 is filled in the conductive dam 391, is distributed on a top surface of the electronic component 320 and bent to extend on a side surface of the electronic component 320, and is distributed on a side surface of the electronic component 320 and bent to extend on a bottom surface of the component body 321 and a surface of the connection end 322, so as to cover the electronic component 320. Certainly, in some other embodiments, the insulation adhesive 380 may not cover the connection end 322. For ease of understanding and description, subsequently, a surface of the insulation colloid 380 in an area on a top surface of the electronic component 320 is referred to as a top surface of the insulation colloid 380, and a surface of the insulation colloid 380 in an area on a side surface of the electronic component 320 is referred to as a side surface of the insulation colloid 380.

The technical term "fill" in this embodiment of this application refers to a state in which a surface of the filler is bonded to the surface of the filler. In this embodiment, a side surface of the insulation colloid 380 is bonded to an inner wall surface (facing a side surface of the electronic component 320) of the conductive dam 391. In this case, the conductive dam 391 extends along the side of the insulation colloid 380 to the PCB 310, specifically extending to the ground pad 370 of the PCB 310 being electrically connected to the ground pad 370 of the PCB 310. In this way, in one aspect, the conductive dam 391 may block the insulation colloid 380 in a process of filling the insulation colloid 380 to prevent its overflow. In addition, the ground pad 370 is connected to the shielding film 392 by using the conductive dam 391, so that the shielding film 392 can be grounded by using the conductive dam 391, and reliability of grounding of the shielding film 392 can be improved.

In a specific implementation process, the insulation colloid 380 may be filled by using a spraying process. When the coating process is used for filling, a material of the insulation colloid 380 may be insulation glue. The insulation glue may be an epoxy resin, a PBO, a PI, a Parylene, a PET, PTFE, a TPU, a FEP, a PFA, an HDPE, or an organic/inorganic composite material with insulation heat. Due to high fluidity of the insulation glue, complete filling around the device (between the device bottom and the device) without holes can be implemented, so that the electronic component 320 is fully coated, and strength of the circuit board assembly 300 is increased. Certainly, in some other embodiments, the insulating adhesive 380 may also be formed by another process such as a glue dispensing process.

It may be understood that because the conductive dam 391 is formed on a surface of the ground pad 370, and the insulation colloid 380 is filled in the conductive dam 391, the conductive dam 391 may be separated from the electronic component 320 by using an area in which the insulation colloid 380 is located between the ground pad 370 and the side surface of the electronic component 320. In this way, the ground pad 370 does not need to avoid the electronic component 320 by using a relatively wide gap width shown in FIG. 3, but may implement isolation between the electronic component 320 and the conductive dam 391 by using a relatively thin insulation colloid 380. Compared with the conventional solution shown in FIG. 3, the circuit board assembly has a layout area gain, which facilitates miniaturization of the whole unit.

Next, the shielding film 392 is described.

The shielding film 392 is attached to the top surface of the insulation colloid 380 and extends to a top end of the conductive dam 391 that is away from the PCB 310, and is electrically connected to the conductive dam 391. Specifically, the shielding film 392 extends to the top of the conductive dam 391, and is electrically connected to the conductive dam 391 in a manner attached to the top of the conductive dam 391.

It may be understood that, because the insulation colloid 380 faces the top surface of the corresponding electronic component 320, the shielding film 392 is naturally also located on a side facing the top surface of the electronic component 320. In addition, the conductive dam 391 is located on a side facing the side facing the electronic component 320, and the shielding film 392 is electrically connected to a top end of the conductive dam 391 to form a shielding cavity of a shielding structure, and the electronic component 320 is covered with the PCB 310.

In a specific implementation process, the shielding film 392 may be formed by any one of a spraying process, a printing process, or a coating process. It should be noted that, compared with the insulation film 330 shown in FIG. 5, the insulation colloid 380 formed by using the spraying process is thicker and occupies more Z-direction space. Therefore, to compensate for occupied Z-direction space of the insulation colloid 380, the shielding film 392 is formed by using a spraying process, a printing process, and a coating process in this embodiment. Compared with a hot pressing process, a thickness of a shielding film 392 formed by a spraying process, a printing process, and a coating process is thinner, so that occupation of Z-direction space can be reduced, thereby facilitating further miniaturization and lightening of a terminal device. Certainly, in some other embodiments, the shielding film 392 may also be formed by using a hot pressing process.

In the circuit board assembly shown in FIG. 21, the insulation colloid 380 is distributed on a top surface, a side surface, and a bottom surface of the electronic component 320, and the conductive dam 391 and the shielding film 392 are respectively on a side surface and a top surface of the insulation colloid 380, so that the insulation colloid 380 is insulated between the shielding film 392 and a conductive structure formed by the conductive dam 391 and the electronic component 320. It can be learned that, different from the shielding cover 11 shown in FIG. 3, the circuit board assembly no longer relies on gap insulation, but relies on insulation colloid 380 for insulation. It may be understood that an insulation effect of the insulation colloid 380 is higher than an insulation effect of a gap in FIG. 3, so that the insulation colloid 380 may be made thinner (compared with a gap size) and attached to a surface of the electronic component 320. When the insulation colloid 380 may be made thinner and the shielding film 392 and the conductive dam 391 are also attached to the surface of the insulation colloid 380, the shielding structure formed by the shielding film 392 and the conductive dam 391 may be closer to the electronic component 320 and cover the electronic component 320, so that a height of the shielding structure is shorter than a shielding cover, thereby reducing space waste in the Z-direction, and further contributing to further miniaturization and lightening of the terminal device.

In addition, in the circuit board assembly shown in FIG. 21, only one row of ground pads 370 may be disposed between two adjacent electronic components 320 that need to be isolated. Different from the circuit board assembly shown in FIG. 5, the shielding film 392 may be electrically connected to the row of ground pads 370 by using the conductive dam 391, to form a first shielding cavity covering the first electronic component 320a and a second shielding cavity covering the second electronic component 320b.

Compared with a conventional shielding solution in which two rows of ground pads 370 are disposed in FIG. 3, only one row of ground pads 370 may be disposed between two adjacent electronic components 320 that need to be isolated, so that a layout area gain is obtained, and the whole system is miniaturized. For specific reasons, refer to related descriptions in FIG. 5 for adaptability.

The foregoing content describes a difference between the new board-level shielding integration solution shown in FIG. 21 and the conventional shielding solution shown in FIG. 3. It may be understood that the insulation colloid 380 may completely fill a device (between the device bottom and the device bottom) and have no holes. Therefore, the insulation colloid 380 is completely coated with the electronic component 320, so that reliability problems such as stripping and delamination in FIG. 4 do not easily occur in the insulation colloid 380. Therefore, reliability of a circuit board assembly in a board-level application environment can be improved. For a specific reason, reference may be made to related analysis in FIG. 5, and details are not described herein again.

In some embodiments of this application, still referring to FIG. 21, a ratio of a wall height b to a wall width a of the conductive dam 391 is 2.4~6. For example, the ratio of the wall height b and the wall width a of the conductive dam 391 may be 2.4, 3.1, 3.8, 4.3, 5.5, and 6. The wall height b of the conductive dam 391 refers to a height of the conductive dam 391 in the Z direction, and the wall width a of the conductive dam 391 refers to a thickness of the conductive dam 391 in the X direction. A wall width a of the conductive dam 391 is related to a width of a ground pad 370 connected to the conductive dam 391. The wall height b of the conductive dam 391 is related to the electronic component 320 enclosed by the conductive dam 391. A specific value of the ratio of the wall height b to the wall width a of the conductive dam 391 is determined according to the ratio of the height of the electronic component 320 enclosed by the conductive dam 391 to the width of the ground pad 370, and may float on the basis of the ratio of the height of the electronic component 320 enclosed by the conductive dam 391 to the width of the ground pad 370. This ratio should not be too large. Otherwise, it is easy to collapse during processing and cannot be shaped.

The foregoing embodiment describes a structure of a circuit board assembly formed by a new board-level shielding integration solution. The following exemplarily describes a processing method of a circuit board assembly formed by the foregoing new board-level shielding integration solution.

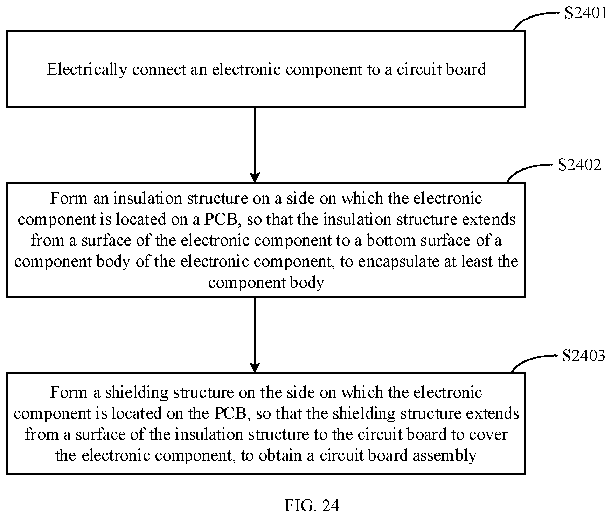

For example, referring to FIG. 24, FIG. 24 is a flowchart of a circuit board assembly processing method according to an embodiment of this application. The method includes the following step S2401 to step S2403:
Step S2401: Electrically connect an electronic component to a PCB.
Step S2402: Form an insulation structure on a side on which the electronic component is located on the PCB, so that the insulation structure extends from a surface of the electronic component to a bottom surface of a component body of the electronic component, to encapsulate at least the component body.
Step S2403: Form a shielding structure on the side on which the electronic component is located on the PCB, so that the shielding structure extends from a surface of the insulation structure to the PCB to cover the electronic component, to obtain a circuit board assembly.
Step S2403 after step S2402, represents that the shielding structure in step S2403 completes a formation process after the insulation structure in step S2402, but does not represent that the formation process of the shielding structure in step S2403 starts before the formation process of the insulation structure in step S2402, which is embodied in a subsequent embodiment.

The following separately uses the circuit board assembly shown in FIG. 5 and the circuit board assembly shown in FIG. 21 as examples to describe a processing method of the circuit board assembly.

First, the circuit board assembly shown in FIG. 5 is used as an example for description.

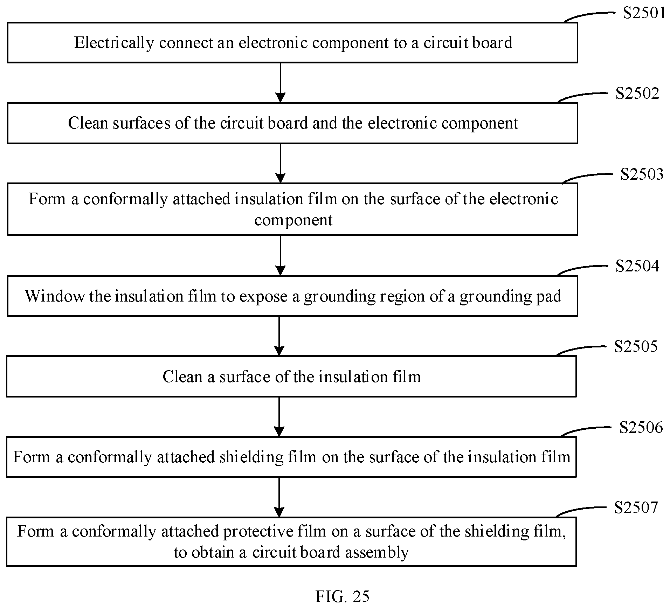

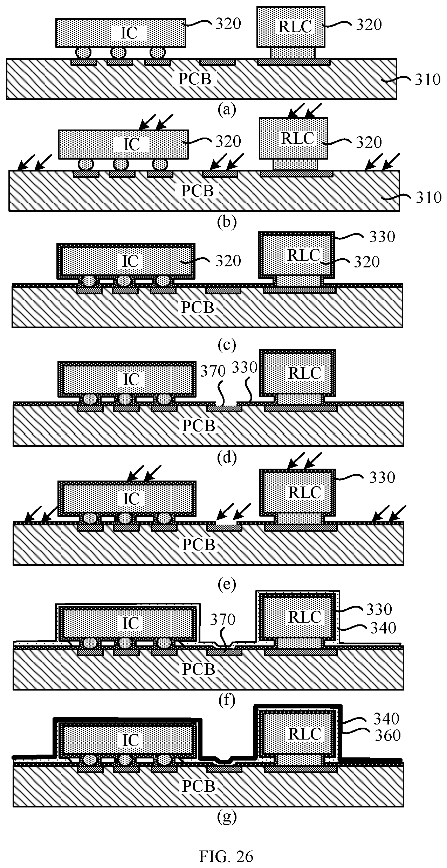

For example, referring to FIG. 25 and FIG. 26, FIG. 25 is a flowchart of a processing method of a circuit board assembly 300 shown in FIG. 5 according to an embodiment of this application, and FIG. 26 is a structural process flowchart corresponding to the processing method shown in FIG. 25. The processing method of the circuit board assembly shown in FIG. 25 includes step S2501 to step S2507.

Step S2501: Electrically connect an electronic component 320 to a PCB 310.

For example, as shown in (a) in FIG. 26, the electronic component 320 (as shown in an IC and an RLC) may be electrically connected to the PCB 310 in a Surface Mounted Technology (Surface Mounted Technology, SMT) manner and the like.

It may be understood that related content in step S2501 may be understood as refining step S2401.

Step S2502: Clean surfaces of the PCB 310 and the electronic component 320.

For example, as shown in (b) in FIG. 26, plasma (Plasma) cleaning may be performed on the PCB 310 and the surface of the electronic component 320. According to this step, surface dirt of the PCB 310 and the electronic component 320 may be removed, so as to improve hydrophilicity.

In a specific implementation process, a water drop angle of the surface of the PCB 310 and the surface of the electronic component 320 is used as a target for cleaning at 20°~30°. It should be noted that the droplet angle is an angle between the gas-liquid interface and the solid-liquid interface at the interface between solid, liquid and gas. The higher the droplet angle, the more hydrophilic the surface is. A lower droplet angle represents a higher hydrophobicity, and a surface is less easily pasted.

Step S2503: Form a conformally attached insulation film 330 on the surface of the electronic component 320.

For example, as shown in (c) in FIG. 26, the insulation film 330 may be deposited on the surface of the electronic component 320 by using a coating process (such as a CVD or a PVD). The insulation film 330 formed by the coating process may be attached to a surface of the electronic component 320 with a thickness of 0.5 um~40 µm, and a thickness is uniform.

It may be understood that the insulation film 330 is used as the insulation structure in step S2402 in FIG. 24. Step S2503 may be understood as a refinement of step S2402.

Step S2504: Window the insulation film 330 to expose a grounding region of a ground pad 370.

For example, as shown in (d) in FIG. 26, the insulation film 330 may be windowed by using a laser window or the like, so as to escape a ground area of the ground pad 370.

It should be noted that in (c) in FIG. 26, the insulation film 330 is integrated on a side on which the electronic component 320 is located. The insulation film 330 is attached not only to a surface of the electronic component 320 but also to a surface on which the PCB is not occupied by the electronic component 320, and the insulation film 330 covers the ground pad 370 laid on the surface of the PCB. Therefore, a window needs to be opened to the insulation film 330, so that the ground pad 370 is leaked, so that the insulation film 330 is electrically connected to the shielding film 340 subsequently.

Step S2505: Clean a surface of the insulation film 330.

For example, as shown in (e) in FIG. 26, plasma cleaning may be performed on the surface of the insulation film 330. By using this step, surface dirt of the PCB 310 and the electronic component 320 may be removed, so as to improve hydrophilicity. In a specific implementation process, a water drop angle of the surface of the PCB 310 and the surface of the electronic component 320 is used as a target for cleaning at 20°~30°.

Step S2506: Form a conformally attached shielding film 340 on a surface of the insulation film 330 by using a hot pressing process.

For example, as shown in (f) in FIG. 26, for the circuit board assembly shown in FIG. 5, a semi-curable conductive adhesive may be used, and a to-be-curable shielding film is formed by pressing the insulation film 330 on a surface by using a hot pressing process. A thickness of the to-be-cured shielding film 340 formed by the hot pressing process is 15 µm~100 µm.

In a specific implementation process, a to-be-cured shielding film 340 may be formed by press-bonding in a high temperature (60°C~180°C), vacuum degree (10-2 Pa~10-3 Pa), and high pressure (1 MPa~2 MPa) environment. In (f) in FIG. 26, the to-be-cured shielding film 340 extends along the surface of the insulation film 330 to the ground pad 370 on the PCB 310, and is bonded to the ground area leaked from the ground pad 370, thereby forming an electrical connection relationship.

It may be understood that the shielding film 340 herein is used as a shielding structure in step S2403 in FIG. 24, and related content of step S2506 may be understood as refinement of step S2403.

After the to-be-cured shielding film 340 is formed, the to-be-cured shielding film 340 may be further cured to form the shielding film 340. In a specific implementation process, a curing temperature may be 60°C~180°C, and a curing time may be 0.5h-4h.

Step S2507: Form a conformally attached protective film 360 on a surface of the shielding film 340 to obtain the circuit board assembly shown in FIG. 5.

For example, as shown in (g) in FIG. 26, the protective film 360 may be formed on the surface of the shielding film 340 by using a hot pressing process, a spraying process, or a coating process, to obtain the circuit board assembly 300 shown in FIG. 5. The protective film 360 formed by the hot pressing process may be attached to the surface of the shielding film 340 with a thickness of 5 µm~15 µm. Certainly, in a specific implementation process, before S2507, a surface of the shielding film 340 may be further cleaned. After S2507, the protective film 360 may be further cured.

FIG. 25 and FIG. 26 describe processing methods of the circuit board assembly shown in FIG. 5 by using an example. It may be understood that, for the circuit board assembly shown in FIG. 19, there is a difference between the processing method of the circuit board assembly shown in FIG. 19 and the processing method shown in FIG. 25 in step S2506. The difference is specifically that a shielding film 340 is formed on a surface of the insulation film 330 by using a spraying process or a printing process.

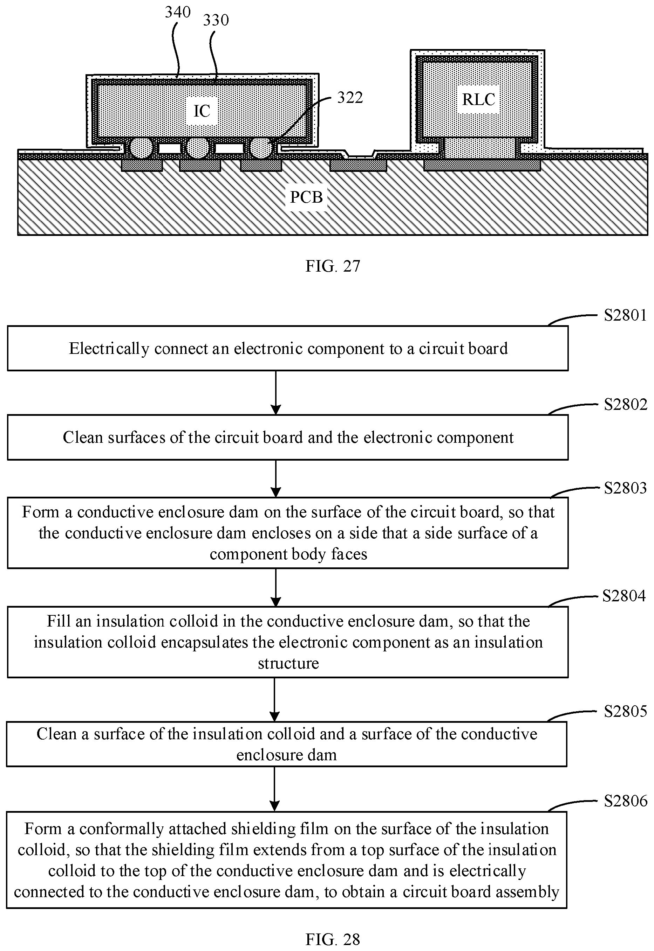

In a specific implementation process, as shown in FIG. 27, FIG. 27 is a structural technical diagram of a shielding film 340 of a circuit board assembly 300 shown in FIG. 19. In FIG. 27, a to-be-cured shielding film 340 may be formed on a surface of the insulation film 330 by using a shielding material having a conductive characteristic such as a conductive adhesive or a conductive ink, and by using a spraying process or a printing process. The to-be-cured shielding film 340 does not extend between the connection ends 322.

After the to-be-cured shielding film 340 is formed, the to-be-cured shielding film 340 may be further cured to form the shielding film 340, and a thickness thereof is 2 µm~40 µm.

In a specific implementation process, a curing temperature may be 60°C~180°C, and a curing time may be 0.5h-4h.

Next, the circuit board assembly shown in FIG. 21 is used as an example for description.

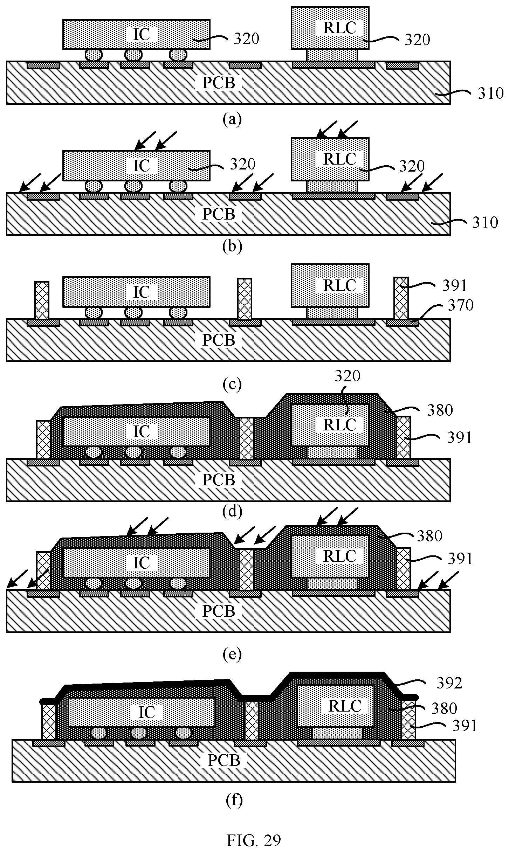

For example, referring to FIG. 28 and FIG. 29, FIG. 28 is a flowchart of a processing method of a circuit board assembly 300 shown in FIG. 21 according to an embodiment of this application, and FIG. 29 is a structural process flowchart corresponding to the processing method shown in FIG. 28. The processing method of the circuit board assembly shown in FIG. 28 includes step S2801 to step S2806.

Step S2801: Electrically connect an electronic component 320 to a PCB 310, as shown in (a) in FIG. 29.

Step S2802: Clean surfaces of the PCB 310 and the electronic component 320, as shown in (b) in FIG. 29.

Step S2803: Form a conductive enclosure dam 391 on the surface of the PCB 310, so that the conductive enclosure dam 391 encloses on a side that a side surface of an electronic component 320 faces.

For example, as shown in (c) in FIG. 29, the to-be-cured conductive dam 391 may be formed on the PCB 310 surface by using the conductive adhesive and by using a glue dispensing process. In a specific implementation process, a to-be-cured conductive dam 391 is formed on a surface of the ground pad 370 on the surface of the PCB 310, so that the to-be-cured conductive dam 391 is electrically connected to the ground pad 370.

After the to-be-cured conductive dam 391 is formed, the to-be-cured conductive dam 391 may further be cured to form the conductive dam 391. In a specific implementation process, a curing temperature may be 60°C~180°C, and a curing time may be 0.5 h-4 h.

It may be understood that the conductive dam 391 is formed on a surface on a side on which the electronic component 320 on the PCB 310 is located (that is, an upper surface shown in FIG. PCB 310), so that the conductive dam 391 can be enclosed on a side facing the side of the component body 321. The conductive dam 391 is formed on the surface of the PCB 310, and naturally extends to the PCB 310.

Step S2804: Fill the insulation colloid 380 in the conductive dam 391, so that the insulation colloid 380 covers the electronic component 320 as an insulation structure.

For a meaning of covering the electronic component 320 by the insulation colloid 380, refer to the foregoing related description in FIG. 20. Details are not described herein again.

For example, as shown in (d) in FIG. 29, the conductive adhesive with fluidity may be filled into the conductive dam 391 by using a spraying process, to form the to-be-cured insulating adhesive 380.

In a specific implementation process, a height at which the to-be-cured insulating adhesive 380 contacts the conductive dam 391 may not exceed a height of the conductive dam 391, so as to reduce a risk that the to-be-cured insulating adhesive 380 overflows at the position. It may be understood that, when the to-be-cured insulation adhesive 380 overflows in contact with the position of the conductive dam 391, the conductive dam 391 attaches insulation adhesive to the top end of the PCB 310, so that the conductive dam 391 cannot form an electrical connection relationship with the shielding film 392 in a subsequent structural process shown in (e) in FIG. 29.

After the to-be-cured insulation colloid 380 is formed, the to-be-cured insulation colloid 380 may be further cured to form the insulation colloid 380. In a specific implementation process, a curing temperature may be 60°C~180°C, and a curing time may be 0.5h-4h.

It may be understood that related content in step S2804 may be understood as refining step S2402.

Step S2805: Clean the surface of the insulation colloid 380 and the surface of the conductive dam 391.

For example, as shown in (e) in FIG. 29, plasma cleaning may be performed on the surface of the insulation film 330 and the surface of the conductive dam 391. For specific implementation, refer to the foregoing related description in (e) in FIG. 29.

Step S2806: Form a conformally attached shielding film 392 on a surface of the insulating rubber 380, so that the shielding film 392 extends from a top surface of the insulating rubber 380 to a top surface of the conductive dam 391, and is electrically connected to the conductive dam 391 to obtain the circuit board assembly 300 shown in FIG. 21.

For example, as shown in (f) in FIG. 29, the shielding film 392 may be formed on the surface of the insulation colloid 380 by using a spraying process or a coating process. A shield film 392 formed by a spraying process or a coating process has a uniform thickness, and a thickness is 2 µm~40 µm.

It should be noted that when the shield film 392 is formed by using the spraying process, after the to-be-cured shield film 392 is formed by using the spraying process, the to-be-cured shield film 392 is cured, and the shield film 392 is formed. In a specific implementation process, a curing temperature may be 60°C~180°C, and a curing time may be 0.5h-4h.

It may be understood that a shielding film 392 and a conductive dam 391 that are electrically connected herein are used as a shielding structure in step S2403 in FIG. 24, and related content of step S2803 and step S2806 may be understood as refinement of step S2403.

It should be noted that the embodiments shown in FIG. 24 to FIG. 28 roughly describe a processing method and a process of a circuit board assembly. For specific implementation and implementation effects of the circuit board assembly, refer to descriptions of the circuit board assembly in the foregoing related embodiments.

It should be understood that in the circuit board assembly processing method in the embodiments shown in FIG. 24 to FIG. 28, sequence numbers of the steps do not mean execution sequences. The execution sequences of the procedures should be determined based on functions and internal logic of the procedures, and should not be construed as any limitation on the implementation procedures of the embodiments of this application. In addition, the processing method of the circuit board assembly in the embodiments shown in FIG. 24 to FIG. 28 may further include more steps. This is not specifically limited in this embodiment of this application.

Finally, it should be noted that, in the descriptions of this specification, specific features, structures, and the like may be properly combined in any one or more embodiments or examples. In addition, the foregoing embodiments are merely used to describe the technical solutions of this application, but are not used to limit this application. Although this application is described in detail with reference to the foregoing embodiments, it should be understood by a person of ordinary skill in the art that the technical solutions described in the foregoing embodiments may still be modified, or some technical features thereof are equivalently replaced. These modifications or replacements do not make the essence of the corresponding technical solutions depart from the spirit and scope of the technical solutions of the embodiments of this application.

## Claims

1. A circuit board assembly, comprising:
a circuit card;
an electronic component, wherein the electronic component is electrically connected to the circuit board;
an insulation structure, wherein the insulation structure extends from a surface of the electronic component to a bottom surface of a component body of the electronic component, to encapsulate at least the component body, and the bottom surface of the component body is a surface that is of the component body and that faces the circuit board; and
a shielding structure, wherein the shielding structure extends from a surface of the insulation structure to the circuit board, to cover the electronic component.

2. The circuit board assembly according to claim 1, wherein the component body is electrically connected to the circuit board through a connection end located at a bottom of the component body, and the bottom of the component body is a side that the bottom surface of the component body faces; and
the insulation structure further extends from the bottom surface of the component body to a surface of the connection end, to encapsulate the connection end.

3. The circuit board assembly according to claim 1 or 2, wherein the insulation structure is an insulation film, and the insulation film is conformally attached to a top surface of the electronic component and extends to a side surface of the electronic component, and is conformally attached to the side surface of the electronic component and extends to at least the bottom surface of the component body.

4. The circuit board assembly according to claim 3, wherein the electronic component is a chip, and a component body of the chip is electrically connected to the circuit board through a plurality of chip solder ends; and
the insulation film extends to at least a bottom surface of the component body of the chip when at least one of the following conditions is met:
a bottom gap H1 of the chip meets 10 µm≤H1≤150 µm;
a recessed dimension of the chip solder end meets W1≥100 µm;
a height D1 of the chip solder end meets 150 µm≤D1≤300 µm; and
a center distance D2 between two adjacent chip solder ends meets 300 µm≤D2≤600 µm.

5. The circuit board assembly according to claim 3 or 4, wherein the electronic component is a passive element, and a component body of the passive element is electrically connected to the circuit board through a plurality of element solder ends; and
when a bottom gap of the passive element meets H2≤30 µm and/or a recessed dimension of the element solder end meets W2≥30 µm, the insulation film extends to at least a bottom surface of the component body of the passive element.

6. The circuit board assembly according to any one of claims 3 to 5, wherein there is a groove on the surface of the electronic component; and
when a groove width H3 of the groove meets 100 µm≤H3≤700 µm and/or a groove depth of the groove meets W3≥20 µm, the insulation film is conformally attached to an inner wall surface of the groove.

7. The circuit board assembly according to any one of claims 3 to 6, wherein there are a plurality of electronic components, and there is a gap between the plurality of electronic components; and
the insulation structure extends into the gap, and extends to the bottom surface of the component body of the electronic component along a side surface that is of each electronic component and that corresponds to the gap, to encapsulate at least the component body of each electronic component.

8. The circuit board assembly according to claim 7, wherein a width of the gap is 1 µm~50 µm.

9. The circuit board assembly according to any one of claims 3 to 8, wherein a thickness difference indicator of the insulation film meets T≤10%, wherein T=(Ta-Tb)/Ta, and Ta and Tb are thicknesses at any two positions of the insulation film.

10. The circuit board assembly according to any one of claims 3 to 9, wherein a thickness at any position of the insulation film is 0.5 µm~40 µm.

11. The circuit board assembly according to any one of claims 3 to 10, wherein the insulation film is implemented by using a coating process.

12. The circuit board assembly according to any one of claims 3 to 11, wherein the shielding structure is a shielding film, and the shielding film is conformally attached to a surface of the insulation film and extends to the circuit board.

13. The circuit board assembly according to claim 12, wherein a thickness at any position of the shielding film is 2 µm~40 µm.

14. The circuit board assembly according to claim 1 or 2, wherein the insulation structure is an insulation colloid, and the shielding structure comprises a conductive frame and a shielding film;
the conductive frame encloses a side that a side surface of the electronic component faces;
the insulation colloid is filled in the conductive frame, is distributed on a top surface of the electronic component and extends to the side surface of the electronic component, and is distributed on the side surface of the electronic component and extends to at least the bottom surface of the component body, and a side that the bottom surface of the component body faces is the bottom surface of the component body;
an inner wall surface of the conductive frame fits a side surface of the insulation colloid, and extends to the circuit board along the side surface of the insulation colloid; and
the shielding film is conformally attached to a top surface of the insulation colloid, extends to a top end that is of the conductive frame and that is away from the circuit board, and is electrically connected to the conductive frame, the side surface of the insulation colloid is a region that is of a surface of the insulation colloid and that corresponds to the side surface of the electronic component, and a top surface of the insulation colloid is a region that is of the surface of the insulation colloid and that corresponds to the top surface of the electronic component.

15. The circuit board assembly according to claim 14, wherein a ratio of a wall height to a wall width of the conductive frame is 2.4~6.

16. The circuit board assembly according to claim 14 or 15, wherein the insulation colloid is formed by using a spraying process.

17. The circuit board assembly according to any one of claims 12 to 16, wherein the shielding film is formed by using any one of a spraying process, a printing process, a coating process, or a hot pressing process.

18. The circuit board assembly according to any one of claims 1 to 17, wherein the shielding structure has a first shielding cavity and a second shielding cavity, the first shielding cavity is used to cover a first electronic component on the circuit board, the second shielding cavity is used to cover a second electronic component on the circuit board, the first electronic component and the second electronic component are two adjacent electronic components on the circuit board, a row of ground terminals are distributed between the first electronic component and the second electronic component, and the shielding structure is electrically connected to the row of ground terminals to form the first shielding cavity and the second shielding cavity.

19. A circuit board assembly processing method, comprising:
electrically connecting an electronic component to a circuit board;
forming an insulation structure on a side on which the electronic component is located on the circuit board, so that the insulation structure extends from a surface of the electronic component to a bottom surface of a component body of the electronic component, to encapsulate at least the component body; and
forming a shielding structure on the side on which the electronic component is located on the circuit board, so that the shielding structure extends from a surface of the insulation structure to the circuit board to cover the electronic component, to obtain a circuit board assembly.

20. The processing method according to claim 19, wherein the forming an insulation structure and a shielding structure on a side on which the electronic component is located on the circuit board comprises:
forming a conformally attached insulation film on the surface of the electronic component, so that the insulation film is used as the insulation structure to encapsulate at least the component body; and
forming a conformally attached shielding film on a surface of the insulation film, so that the shielding film is used as the shielding structure to extend from the surface of the insulation film to the circuit board.

21. The processing method according to claim 20, wherein the forming a conformally attached insulation film on the surface of the electronic component comprises:
forming the insulation film on the surface of the electronic component by using a coating process.

22. The processing method according to claim 19, wherein the forming an insulation structure and a shielding structure on a side on which the electronic component is located on the circuit board comprises:
forming a conductive frame on a surface of the circuit board, so that the conductive frame encloses a side that a side surface of the electronic component faces;
filling insulation glue in the conductive frame to form an insulation colloid, wherein the insulation colloid is used as the insulation structure to encapsulate at least the component body; and
forming a conformally attached shielding film on a top surface of the insulation colloid, so that the shielding film extends from the top surface of the insulation colloid to a top end that is of the conductive frame and that is away from the circuit board, and is electrically connected to the conductive frame, wherein the shielding film and the conductive frame form the shielding structure.

23. The processing method according to claim 22, wherein the filling insulation glue in the conductive frame comprises:
filling the insulation glue in the conductive frame by using a spraying process.

24. The processing method according to any one of claims 20 to 23, wherein the forming a conformally attached shielding film comprises:
forming the conformally attached shielding film by using any one of a spraying process, a printing process, a coating process, or a hot pressing process.

25. A terminal device, comprising:
a housing; and
the circuit board assembly according to any one of claims 1 to 18 or a circuit board assembly processed by using the method according to any one of claims 19 to 24, wherein the circuit board assembly is located in the housing.
